(19)

Europäisches Patentamt
European Patent Office
Office européen des brevets

(11) **EP 4 257 734 A1**

(12) **EUROPEAN PATENT APPLICATION**

published in accordance with Art. 153(4) EPC

(43) Date of publication:
**11.10.2023 Bulletin 2023/41**

(21) Application number: **22736564.0**

(22) Date of filing: **06.01.2022**

(51) International Patent Classification (IPC):
**C30B 29/06** (2006.01)    **C30B 15/20** (2006.01)

(52) Cooperative Patent Classification (CPC):
Y02P 70/50

(86) International application number:
**PCT/CN2022/070545**

(87) International publication number:
**WO 2022/148402 (14.07.2022 Gazette 2022/28)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority:  08.01.2021  CN 202110024166
      25.08.2021  CN 202110984273

(71) Applicant: **Longi Green Energy Technology Co., Ltd.**
**Xi'an, Shaanxi 710100 (CN)**

(72) Inventors:
• **DENG, Hao**
  **Xi'an, Shaanxi 710100 (CN)**
• **XIE, Zhiyan**
  **Xi'an, Shaanxi 710100 (CN)**
• **JIN, Qian**
  **Xi'an, Shaanxi 710100 (CN)**

(74) Representative: **von Bülow & Tamada**
**Rotbuchenstraße 6**
**81547 München (DE)**

(54)  **CRYSTAL PULLING PROCESS FOR SINGLE-CRYSTAL SILICON**

(57)    A crystal pulling process for single-crystal silicon doped with a volatile dopant. The crystal pulling process comprises using a low furnace pressure of no more than 18 Torr in a single-crystal furnace during an equal-diameter stage of crystal growth, and keeping the flow of argon gas introduced into the single-crystal furnace in a constant range, so as to achieve equal-diameter crystal pulling under a low furnace pressure. By means of the process, the axial resistivity attenuation slope of the single crystal doped with the volatile dopant, especially gallium, can be reduced, and the resistivity effective length thereof can be increased.

FIG. 1

Processed by Luminess, 75001 PARIS (FR)

**Description**

**CROSS-REFERENCE TO RELATED APPLICATION**

The present disclosure claims the priority of the Chinese patent application filed on August 25, 2021 before the China National Intellectual Property Administration with the application number of 202110984273.4 and the title of "CRYSTAL PULLING PROCESS FOR SINGLE-CRYSTAL SILICON", and the priority of the Chinese patent application filed on January 8, 2021 before the China National Intellectual Property Administration with the application number of 202110024166.7 and the title of "CRYSTAL PULLING PROCESS FOR SINGLE-CRYSTAL SILICON", the entire content of which is incorporated herein by reference.

**FIELD**

The present disclosure belongs to the technical field of growth of monocrystalline silicon, and in particular relates to a crystal-pulling method for pulling monocrystalline silicon doped with a dopant (including a volatile dopant), with a given target resistivity, under a CZ process, in particular to a crystal-pulling method for pulling gallium-doped monocrystalline silicon. In a crystal-growth process, accuracy of a resistivity of a head of a crystal rod is controlled, and production efficiency and yield are improved.

**BACKGROUND**

With an environmental crisis brought about by global-climate change and an energy crisis caused by over-exploitation of fossil energy, people are paying more and more attention to development of clean energy, and photovoltaic power generation, as the most-representative clean energy, has been paid more and more attention and vigorously developed by the world.

At present, a main basic material for photovoltaic power generation is gallium-doped P-type monocrystal. Compared with traditional boron-doped monocrystal, since it avoids generation of BO complex, it may effectively reduce initial light-induced degradation (LID), which ensures that a P-type photovoltaic module can maintain high-efficiency, stable and reliable operation for a long time.

However, a segregation coefficient of gallium is very low, only 0.008. The resistivities of a head and a tail of gallium-doped monocrystal are generally set to 1.0 and 0.4 respectively. According to a principle of segregation, during growth of a crystal rod, the resistivity of the crystal rod will gradually decrease with increase of its length, which limits the length of the crystal rod whose resistivity is within an effective range, at the same time, oxygen content will increase, and a minority-carrier lifetime of the crystal rod will decrease.

**SUMMARY**

The present disclosure aims to solve problems that a monocrystal doped with a dopant (especially a volatile dopant, such as gallium) has a relatively fast degradation rate of resistivity in an axial thereof, and a range of a length thereof with an effective resistivity is limited in principle, and problems that oxygen content thereof increases, and a minority-carrier lifetime thereof decreases.

Specific technical solutions of the present disclosure are as follows:

1. A crystal-pulling method for pulling monocrystalline silicon, wherein the crystal-pulling method includes that a furnace pressure of a monocrystal furnace in an equal-diameter stage of growth of a crystal does not exceed 18 Torr, a flow rate of argon gas introduced into the monocrystal furnace is kept in a constant range, and the monocrystalline silicon is doped with a dopant.

2. The crystal-pulling method for pulling the monocrystalline silicon according to item 1, wherein the furnace pressure of the monocrystal furnace is gradually reduced as a length of a crystal rod increases in the equal-diameter stage of the growth of the crystal.

3. The crystal-pulling method for pulling the monocrystalline silicon according to item 2, wherein the furnace pressure of the monocrystal furnace in the equal-diameter stage of the growth of the crystal does not exceed 15 Torr; and preferably the furnace pressure of the monocrystal furnace does not exceed 10 Torr.

4. The crystal-pulling method for pulling the monocrystalline silicon according to item 2, wherein, when an equal-diameter length of the monocrystalline silicon is any a length within a range of greater than 0 mm and less than 250 mm, the furnace pressure of the monocrystal furnace is controlled to be $U_{5a}$, and a value of $U_{5a}$ is within a range of 8-15 Torr; when the equal-diameter length of the monocrystalline silicon is within a range of greater than or equal to 250 mm and less than 600 mm, the furnace pressure of the monocrystal furnace is controlled to be $U_{5b}$, and a value of $U_{5b}$ is within a range of 4-12 Torr; and when the equal-diameter length of the monocrystalline silicon is equal to 600 mm or greater than 600 mm, the furnace pressure of the monocrystal furnace is controlled to be $U_{5c}$, and a value of $U_{5c}$ is within a range of 2-8 Torr, wherein $U_{5c} < U_{5b} < U_{5a}$.

5. The crystal-pulling method for pulling the monocrystalline silicon according to item 2, wherein a process that the furnace pressure of the monocrystal furnace is gradually reduced, includes:

when the crystal grows to a preset length, obtaining a value of the furnace pressure, U, of the monocrystal furnace; and

comparing the obtained value of the furnace pressure, U, of the monocrystal furnace with a preset value of the furnace pressure, $U_5$, and when $U > U_5$, reducing the furnace pressure, till $U \le U_5$.

6. The crystal-pulling method for pulling the monocrystalline silicon according to item 5, wherein the process that the furnace pressure of the monocrystal furnace is gradually reduced, includes:

when the crystal grows to the preset length, obtaining the value of the furnace pressure, U, of the monocrystal furnace;

comparing the obtained value of the furnace pressure, U, of the monocrystal furnace with the preset value of the furnace pressure, $U_5$; and

when $U \le U_5$, keeping a frequency of a vacuum pump unchanged; and

when $U > U_5$, increasing the frequency of the vacuum pump, then detecting the value of the furnace pressure, U, of the monocrystal furnace, and comparing a size of U with a size of $U_5$, and when $U \le U_5$, keeping the frequency of the vacuum pump unchanged.

7. The crystal-pulling method for pulling the monocrystalline silicon according to item 5, wherein the process that the furnace pressure of the monocrystal furnace is gradually reduced, includes:

when the equal-diameter length of the monocrystalline silicon grows to any a length within a range of greater than or equal to 100 mm and less than 350 mm, obtaining the value of the furnace pressure, U, of the monocrystal furnace; comparing the obtained value of the furnace pressure, U, of the monocrystal furnace with a preset value of the furnace pressure, $U_{51}$, and when $U > U_{51}$, reducing the furnace pressure, till $U \le U_{51}$, wherein the value of $U_{51}$ is within a range of 6-14 Torr, and preferably the value of $U_{51}$ is within a range of 8-12 Torr;

when the equal-diameter length of the monocrystalline silicon grows to any a length within a range of greater than or equal to 350 mm and less than 600 mm, obtaining the value of the furnace pressure, U, of the monocrystal furnace; comparing the obtained value of the furnace pressure, U, of the monocrystal furnace with a preset value of the furnace pressure, $U_{52}$, and when $U > U_{52}$, reducing the furnace pressure, till $U \le U_{52}$, wherein the value of $U_{52}$ is within a range of 4-10 Torr, and preferably the value of $U_{52}$ is within a range of 5-8 Torr; and

when the equal-diameter length of the monocrystalline silicon grows to any a length within a range of greater than or equal to 600 mm, obtaining the value of the furnace pressure, U, of the monocrystal furnace; comparing the obtained value of the furnace pressure, U, of the monocrystal furnace with a preset value of the furnace pressure, $U_{53}$; and when $U > U_{53}$, reducing the furnace pressure, till $U \le U_{53}$, wherein the value of $U_{53}$ is within a range of 2-8 Torr, and preferably the value of $U_{53}$ is within a range of 2-6 Torr,

wherein $U_{53} < U_{52} < U_{51}$.

8. The crystal-pulling method for pulling the monocrystalline silicon according to item 5, wherein the process that the furnace pressure of the monocrystal furnace is gradually reduced, includes:

when the equal-diameter length of the monocrystalline silicon is any a length within a range of less than 10% of a total length of the crystal rod, obtaining the value of the furnace pressure, U, of the monocrystal furnace; comparing the obtained value of the furnace pressure, U, of the monocrystal furnace with a preset value of the furnace pressure, $U_{51}$; and when $U > U_{51}$, reducing the furnace pressure, till $U \leq U_{51}$, wherein the value of $U_{51}$ is within a range of 4-10 Torr;

when the equal-diameter length of the monocrystalline silicon is any a length within a range of greater than or equal to 10% of the total length of the crystal rod and less than 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{52}$; and when $U > U_{52}$, reducing the furnace pressure, till $U \leq U_{52}$, wherein the value of $U_{52}$ is within a range of 2-4 Torr; and

when the equal-diameter length of the monocrystalline silicon is any a length within a range of greater than or equal to 45% of the total length of the crystal rod, obtaining the value of the furnace pressure, U, of the monocrystal furnace; comparing the obtained value of the furnace pressure, U, of the monocrystal furnace with the preset value of the furnace pressure, $U_{53}$; and when $U > U_{53}$, reducing the furnace pressure, till $U \leq U_{53}$, wherein the value of $U_{53}$ is within a range of 0-2 Torr,

wherein $U_{53} < U_{52} < U_{51}$.

9. The crystal-pulling method for pulling the monocrystalline silicon according to item 5, wherein,

when the equal-diameter length of the monocrystalline silicon is any a length within a range of less than 10% of a total length of the crystal rod, the furnace pressure of the monocrystal furnace is controlled to be $U_{S501}$, and a value of $U_{S501}$ is within a range of 1-3 Torr;

when the equal-diameter length of the monocrystalline silicon is any a length within a range of greater than or equal to 10% of the total length of the crystal rod and less than 45% of the total length of the crystal rod, the furnace pressure of the monocrystal furnace is controlled to be $U_{S502}$, and a value of $U_{S502}$ is within a range of 0.3-2 Torr; and

when the equal-diameter length of the monocrystalline silicon is any a length within a range of greater than or equal to 45% of the total length of the crystal rod, the furnace pressure of the monocrystal furnace is controlled to be $U_{S503}$, and a value of $U_{S503}$ is within a range of 0.01-0.3 Torr,

wherein $U_{S503} < U_{S502} < U_{S501}$.

10. The crystal-pulling method for pulling the monocrystalline silicon according to item 9, wherein,

when the equal-diameter length of the monocrystalline silicon is any a length within the range of less than 10% of the total length of the crystal rod, obtaining the value of the furnace pressure, U, of the monocrystal furnace; comparing the obtained value of the furnace pressure, U, of the monocrystal furnace with a preset value of the furnace pressure, $U_{ssi}$; and when $U > U_{S51}$, reducing the furnace pressure, till $U \leq U_{ssi}$, wherein the value of $U_{ssi}$ is within a range of 1-3 Torr;

when the equal-diameter length of the monocrystalline silicon is any a length within the range of greater than or equal to 10% of the total length of the crystal rod and less than 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S52}$; and when $U > U_{S52}$, reducing the furnace pressure, till $U \leq U_{S52}$, wherein the value of $U_{S52}$ is within a range of 0.3-2 Torr; and

when the equal-diameter length of the monocrystalline silicon is any a length within the range of greater than or equal to 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S53}$; and when $U > U_{S53}$, reducing the furnace pressure, till $U \leq U_{S53}$, wherein the value of $U_{S53}$ is within a range of 0.01-0.3 Torr,

wherein $U_{S53} < U_{S52} < U_{S51}$.

11. The crystal-pulling method for pulling the monocrystalline silicon according to item 5, wherein,

when the equal-diameter length of the monocrystalline silicon is any a length within a range of less than 10% of a total length of the crystal rod, controlling the furnace pressure of the monocrystal furnace to be $U_{S501}$, wherein $U_{S501}$ does not exceed 500 mTorr;

when the equal-diameter length of the monocrystalline silicon is any a length within a range of greater than or equal to 10% of the total length of the crystal rod and less than 45% of the total length of the crystal rod, controlling the furnace pressure of the monocrystal furnace to be $U_{S502}$, wherein $U_{S502}$ does not exceed 300 mTorr; and

when the equal-diameter length of the monocrystalline silicon is any a length within a range of greater than or equal to 45% of the total length of the crystal rod, controlling the furnace pressure of the monocrystal furnace to be $U_{S503}$, wherein $U_{S503}$ does not exceed 100 mTorr,

wherein $U_{S503} < U_{S502} < U_{S501}$.

12. The crystal-pulling method for pulling the monocrystalline silicon according to item 11, wherein,

when the equal-diameter length of the monocrystalline silicon is any a length within the range of less than 10% of the total length of the crystal rod, obtaining the value of the furnace pressure, U, of the monocrystal furnace; comparing the obtained value of the furnace pressure, U, of the monocrystal furnace with a preset value of the furnace pressure, U ssi; and when $U > U_{S51}$, reducing the furnace pressure, till $U \le U_{S51}$, wherein $U_{S51}$ does not exceed 500 mTorr;

when the equal-diameter length of the monocrystalline silicon is any a length within the range of greater than or equal to 10% of the total length of the crystal rod and less than 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S52}$; and when $U > U_{S52}$, reducing the furnace pressure, till $U \le U_{S52}$, wherein the value of $U_{S52}$ does not exceed 300 mTorr; and

when the equal-diameter length of the monocrystalline silicon is any a length within the range of greater than or equal to 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S53}$, and when $U > U_{S53}$, reducing the furnace pressure, till $U \le U_{S53}$, wherein the value of $U_{S53}$ does not exceed 100 mTorr,

wherein $U_{S53} < U_{S52} < U_{S51}$.

13. The crystal-pulling method for pulling the monocrystalline silicon according to any one of items 1-3, wherein the crystal-pulling method further includes: controlling the furnace pressure in a material-melting/feeding stage, a seeding stage, a shoulder-expanding stage and a shoulder-turning stage previous to the equal-diameter stage; and preferably the furnace pressure in the material-melting/feeding stage, the seeding stage, the shoulder-expanding stage and the shoulder-turning stage previous does not exceed 18 Torr, and further preferably the furnace pressure does not exceed 2 Torr.

14. The crystal-pulling method for pulling the monocrystalline silicon according to item 1, wherein, at least in a time in the equal-diameter stage of the growth of the crystal, a value of the furnace pressure, U, of the monocrystal furnace, a percentage L of an equal-diameter length of a crystal rod, the flow rate P of argon gas, and a frequency F of a vacuum pump meet:

$$U = A*L + B*P + D*F + C,$$

wherein $1 \le A \le 10$, $0.01 \le B \le 0.02$, $-0.6 \le D \le -0.2$, and $10 \le C \le 25$, and

a unit of the value of the furnace pressure, U, of the monocrystal furnace is Torr, the percentage L of the equal-diameter length of the crystal rod is a percentage of a pulled length of the crystal rod to a total length of the crystal rod, a unit of the flow rate P of argon gas is SLPM, and a unit of the frequency F of the vacuum pump is Hz.

15. The crystal-pulling method for pulling the monocrystalline silicon according to item 14, wherein the furnace pressure meets 0.001 Torr ≤ U ≤ 15 Torr, the flow rate of argon gas meets 0 SLPM < P ≤ 70 SLPM, and the frequency of the vacuum pump meets 20 Hz ≤ F ≤ 60 Hz.

16. The crystal-pulling method for pulling the monocrystalline silicon according to item 14, wherein a range of the furnace pressure of the monocrystal furnace in the equal-diameter stage of the growth of the crystal is 0-15 Torr, and preferably 2-10 Torr.

17. The crystal-pulling method for pulling the monocrystalline silicon according to item 14, wherein the flow rate of argon gas introduced into the monocrystal furnace is 40-100 SLPM, and preferably 50-70 SLPM.

18. The crystal-pulling method for pulling the monocrystalline silicon according to item 1, wherein, at least in a time in the equal-diameter stage of the growth of the crystal, a value of the furnace pressure, U, of the monocrystal furnace, a percentage L of an equal-diameter length of a crystal rod, the flow rate P of argon gas, and a frequency F of a vacuum pump meet:

$$U = A*L + B*P + D*F + C,$$

wherein $5 \leq A \leq 10$, $0.01 \leq B \leq 0.02$, $-0.6 \leq D \leq -0.2$, and $15 \leq C \leq 20$, and

a unit of the value of the furnace pressure, U, of the monocrystal furnace is Torr, the percentage L of the equal-diameter length of the crystal rod is a percentage of a pulled length of the crystal rod to a total length of the crystal rod, a unit of the flow rate P of argon gas is SLPM, and a unit of the frequency F of the vacuum pump is Hz.

19. The crystal-pulling method for pulling the monocrystalline silicon according to item 18, wherein the value of the furnace pressure is within a range of 2 Torr ≤ U ≤ 10 Torr, the flow rate of argon gas is within a range of 50 SLPM ≤ P ≤ 70 SLPM, and the frequency of the dry pump is within a range of 20 Hz ≤ F ≤ 60 Hz.

20. The crystal-pulling method for pulling the monocrystalline silicon according to any one of items 1-19, wherein the dopant is gallium. A mass percentage of gallium is preferably 0.01%-0.03%.

According to an embodiment of the present disclosure, in the above crystal-pulling method, the vacuum pump is preferably a dry pump.

In the present disclosure, Torr is the unit a pressure, 1 Torr is 1 mmHg, and 1 Torr = 1000 mTorr. SLPM is an abbreviation of stard liter per minute, that is, a standard liter per minute for a flow value.

The technical solution of the present disclosure has following technical effects:

(1) The present disclosure adopts a crystal-pulling method of a crystal-pulling process of a low-pressure furnace, which accelerates volatilization rates of impurity elements including gallium, and reduces the impurity elements in melt, thereby suppressing a degradation rate of a resistivity of a crystal rod and increasing a length of the crystal rod whose resistivity is within an effective range. When the resistivity of a tail thereof is 0.45, the length of the crystal rod increases significantly, a pull-out ratio thereof increases, and a minority-carrier lifetime thereof is greatly improved, reaching more than 10%, an improvement effect of which is significant.

(2) Under the low-pressure furnace of the present disclosure, a melting point of silicon will decrease, an ambient temperature will decrease to a certain extent, a heating temperature of walls of a crucible will decrease accordingly, and a dissolution rate of the crucible will decrease as well, resulting in decreasing in oxygen content, which effectively controls the oxygen content in the crystal, such that the oxygen content of a head of the crystal rod is significantly reduced, and an effect of oxygen reduction is significant.

BRIEF DESCRIPTION OF THE DRAWINGS

FIG. 1 is a chart of degradation trends of resistivities in an axial direction when crystal pulling is simulated under different furnace pressures according to a theoretical model in embodiments of the present disclosure.
FIG. 2 is a view of partial enlargement of a block section of FIG. 1.

**DETAILED DESCRIPTION OF THE EMBODIMENTS**

Subsequent description of the specification illustrates better implementations for carrying out the present disclosure, and the description is for a purpose of general principles of the specification and is not intended to limit a scope of the present disclosure. The scope of protection of the present disclosure should be determined by a scope defined by claims. Specific embodiments of the present disclosure will be described in more detail below with reference to accompanying drawings. While specific embodiments of the present disclosure are shown in the accompanying drawings, it should be understood that the present disclosure may be embodied in various forms and should not be limited by the embodiments set forth herein.

The present disclosure provides a crystal-pulling method for pulling monocrystalline silicon under a low furnace pressure.

The present disclosure adopts a Czochralski method (abbreviated as CZ method) to produce monocrystalline silicon. In the method, a polycrystalline silicon material is placed and melted in a quartz crucible. During a process of pulling monocrystal by the Czochralski method, first, a seed crystal and melt are contacted, to cool molten silicon at a solid-liquid interface to form a crystal along the seed crystal, the crystal grows by slowly pulling out the seed crystal, and after seeding is completed, a growth diameter of the crystal is enlarged by reducing a pulling speed and/or a melt temperature, till a target diameter is reached. After shoulder turning (diameter turning), growth of the crystal enters an "equal-diameter-growth" stage by controlling the pulling speed and the melt temperature; finally, by increasing the pulling speed and increasing the melt temperature, a diameter of a growth surface of the crystal is gradually reduced to form a tail cone, till finally the crystal leaves a surface of the melt, that is, growth of a monocrystalline-silicon rod is completed.

Specifically, taking growth of a silicon rod as an example, a crucible is charged, and all of a silicon material is melted to obtain the melt. After the melt is stabilized, the above temperature-adjustment-operation stage is entered. Then, after the seed crystal is lowered above a liquid surface of the melt by a certain distance, to preheat the seed crystal, to reduce a temperature difference between the seed crystal and the melt, so as to suppress thermal stress generated inside the seed crystal when the seed crystal is in contact with the melt. After the temperature difference between the seed crystal and the melt meets a temperature-requirement range, a seeding stage is entered. In the seeding stage, the seed crystal is inserted into the melt to fuse the seed crystal with the melt. After that, a high pulling speed is often adopted to reduce a diameter of a crystal to a length-requirement range, so as to prevent dislocations in a grown crystal rod. After the seeding stage is completed, the diameter of the crystal needs to be enlarged to the target diameter. Specifically, after a slender neck grows to a sufficient length and a certain pulling speed is reached, the pulling speed can be appropriately reduced to enter a shoulder-expanding (diameter-expanding) stage. When the diameter of the crystal in the shoulder-expanding stage is close to a preset target diameter, in order to make the crystal grown in the shoulder-expanding stage smoothly transition to an equal-diameter stage uniformly in diameter, a shoulder-turning stage needs to be performed. After the diameter of the crystal grows to the preset target diameter, the equal-diameter stage is entered. In the equal-diameter stage, in order to keep isothermal surfaces of the crystal being planes, a height of the crucible will change with rising of the crystal. After an equal-diameter length of the crystal meets a preset target-equal-diameter length, an ending stage is performed. The ending stage acts to preventing a dislocation-reaction phenomenon when the crystal suddenly leaves the surface of the melt, to ensure that the crystal rod grown in an equal-diameter-operation stage has good quality. After the ending stage is over, according to an actual growth situation, it can be chosen to continue feeding and carry out continuous crystal pulling, or enter a furnace-shutdown stage and end crystal-pulling work.

The present disclosure provides a crystal-pulling method for pulling monocrystalline silicon, which is characterized in that the crystal-pulling method includes: that a furnace pressure of a monocrystal furnace does not exceed 18 Torr in an equal-diameter stage of growth of a crystal, that a flow rate of argon gas introduced into the monocrystal furnace is kept being within a constant range, and that the monocrystalline silicon was doped with a dopant.

In an embodiment of the present disclosure, the method optionally includes: a material-melting/feeding stage, a seeding stage, a shoulder-expanding stage, a shoulder-turning stage, and an equal-diameter stage, which specifically are as follows:
In the material-melting/feeding stage S100, a block of a silicon material is placed in a quartz crucible, argon gas is introduced, the furnace pressure is controlled to be 0.5-15 Torr, a material-melting power is controlled to be 60-110 Kw, and the silicon material is heated and melted to form uniform silicon melt, wherein the flow rate of argon gas is controlled to be 10-100 SLPM in an initial stage of the material-melting/feeding stage, and after the block of the silicon material in the crucible is completely melted into a liquid, the initial stage of the material-melting/feeding stage is over, then a temperature-stabilization stage is entered, a thermal field is stabilized to a suitable seeding temperature to be ready to fuse a seed crystal with the silicon melt, and the furnace pressure is controlled to be 0.5-10 Torr and the flow rate of argon gas is controlled to be 10-100 SLPM during the temperature-stabilization stage.

In the seeding stage S200, the seed crystal is fused with the silicon melt, and in order to prevent dislocations generated during a solid-liquid contact, the furnace pressure is controlled to be 0.5-15 Torr, and the flow rate of argon gas is controlled to be 10-100 SLPM, a maximum of which shall not exceed 120 SLPM, and a stable environment for a fusing process is provided, so as to avoid shaking of the seed crystal in the fusing process, and in order to improve a crystal-formation rate, an upper limit of a fusing diameter is controlled to be 16.5 mm, a lower limit of the fusing diameter is controlled to be 13 mm, a minimum diameter is controlled to be 10 mm, and a gain value of seeding is adjusted to 0.085.

In the shoulder-expanding stage S300, a temperature and a pulling speed are adjusted, a diameter of the crystal is enlarged to a required diameter, a diameter of the monocrystalline-silicon rod is 240-310 mm, and the flow rate of argon gas is controlled to be 10-100 SLPM and the furnace pressure is controlled to be 0.5-15 Torr in the shoulder-expanding stage.

In the shoulder-turning stage S400, after the diameter of the crystal reaches a specified requirement, the pulling speed and the temperature are adjusted, to perform shoulder turning, so that the crystal can enter an equal-diameter-growth stage, and the flow rate of argon gas is controlled to be 10-100 SLPM and the furnace pressure is controlled to be 0.5-15 Torr in the shoulder-turning stage.

In the equal-diameter stage S500, after the silicon rod reaches a specified diameter, the equal-diameter stage is entered, and a monocrystal-growth process is controlled by controlling the pulling speed of the monocrystalline-silicon rod and the temperature of the melt in the furnace, and at this stage, the growth of the crystal tends to be stable, and in the monocrystal-growth process, the furnace pressure is gradually reduced as a length of the monocrystalline-silicon rod increases, and after an equal diameter is 200 mm, the furnace pressure is kept being less than 2 Torr, and the flow rate of argon gas is reduced. Other crystal-pulling parameters, such as a power, etc., are synchronously adjusted. A whole process of the equal-diameter stage is automatically controlled by a system.

In an ending stage, as the crystal grows, molten silicon in the crucible decreases continuously, and after a remaining material reaches a certain weight, the diameter of the monocrystalline-silicon rod is reduced by changing the pulling speed and the temperature, so as to reduce a dislocation length generated when the crystal leaves a liquid surface by reducing a thermal shock, and at this stage, the flow rate of argon gas can be increased to be 40-100 SLPM, and the furnace pressure can be controlled to be 0-15 Torr.

......

The above steps are cycled repeatedly, till a production of the furnace is finished.

In an embodiment of the present disclosure, the furnace pressure of the monocrystal furnace is gradually reduced as the length of the crystal rod increases in the equal-diameter stage of the growth of the crystal.

In an embodiment of the present disclosure, the furnace pressure of the monocrystal furnace in the equal-diameter stage of the growth of the crystal does not exceed 15 Torr; preferably, the furnace pressure of the monocrystal furnace does not exceed 10 Torr.

For example, the furnace pressure of the monocrystal furnace can be 0.001, 0.01, 0.02, 0.03, 0.04, 0.05, 0.06, 0.07, 0.08, 0.09, 0.1, 0.15, 0.2, 0.25, 0.3, 0.35, 0.4, 0.45, 0.5, 0.55, 0.6, 0.65, 0.7, 0.75, 0.8, 0.85, 0.9, 0.95, 1, 1.5, 2, 2.5, 3, 3.5, 4, 4.5, 5, 5.5, 6, 6.5, 7, 7.5, 8, 8.5, 9, 9.5, 10, 10.5, 11, 11.5, 12, 12.5, 13, 13.5, 14, 14.5, or 15 Torr, or any range among them.

In an embodiment of the present disclosure, when an equal-diameter length of the monocrystalline silicon is any a length within a range of greater than 0 mm and less than 250 mm, the furnace pressure of the monocrystal furnace is controlled to be $U_{5a}$, and a value of $U_{5a}$ is within a range of 8-15 Torr. When the equal-diameter length of the monocrystalline silicon is within a range of greater than or equal to 250 mm and less than 600 mm, the furnace pressure of the monocrystal furnace is controlled to be $U_{5b}$, and a value of $U_{5b}$ is within a range of 4-12 Torr. When the equal-diameter length of the monocrystalline silicon is equal to 600 mm or greater than 600 mm, the furnace pressure of the monocrystal furnace is controlled to be $U_{5c}$, and a value of $U_{5c}$ is within a range of 2-8 Torr. Among them, $U_{5c} < U_{5b} < U_{5a}$.

In an embodiment of the present disclosure, a process of gradually reducing the furnace pressure of the monocrystal furnace includes:

when the crystal grows to a preset length, obtaining a value of the furnace pressure, U, of the monocrystal furnace; and comparing the obtained value of the furnace pressure, U, of the monocrystal furnace with a preset value of the furnace pressure, $U_5$, and when $U > U_5$, reducing the furnace pressure, till $U \leq U_5$.

In an embodiment of the present disclosure, the process of gradually reducing the furnace pressure of the monocrystal furnace includes:

when the crystal grows to the preset length, obtaining the value of the furnace pressure, U, of the monocrystal furnace; comparing the obtained value of the furnace pressure, U, of the monocrystal furnace with the preset value of the

furnace pressure, $U_5$, and

when $U \le U_5$, keeping a frequency of a vacuum pump unchanged; and

when $U > U_5$, increasing the frequency of the vacuum pump, then detecting the furnace pressure U of the monocrystal furnace, and comparing a size of U with a size of $U_5$, and when $U \le U_5$, keeping the frequency of the vacuum pump unchanged.

In an embodiment of the present disclosure, the process of gradually reducing the furnace pressure of the monocrystal furnace includes:

when the equal-diameter length of the monocrystalline silicon grows to any a length within a range of greater than or equal to 100 mm and less than 350 mm, obtaining the value of the furnace pressure, U, of the monocrystal furnace; comparing the obtained value of the furnace pressure, U, of the monocrystal furnace with a preset value of the furnace pressure, $U_{51}$, and when $U > U_{51}$, reducing the furnace pressure, till $U \le U_{51}$, wherein the value of $U_{51}$ is within a range of 6-14 Torr, preferably the value of $U_{si}$ is within a range of 8-12 Torr;

when the equal-diameter length of the monocrystalline silicon grows to any a length within a range of greater than or equal to 350 mm and less than 600 mm, obtaining the value of the furnace pressure, U, of the monocrystal furnace; comparing the obtained value of the furnace pressure, U, of the monocrystal furnace with a preset value of the furnace pressure, $U_{52}$, and when $U > U_{52}$, reducing the furnace pressure, till $U \le U_{52}$, wherein the value of $U_{52}$ is within a range of 4-10 Torr, preferably the value of $U_{52}$ is within a range of 5-8 Torr; and

when the equal-diameter length of the monocrystalline silicon grows to any a length within a range of greater than or equal to 600 mm, obtaining the value of the furnace pressure, U, of the monocrystal furnace; comparing the obtained value of the furnace pressure, U, of the monocrystal furnace with a preset value of the furnace pressure, $U_{53}$; and when $U > U_{53}$, reducing the furnace pressure, till $U \le U_{53}$, wherein the value of $U_{53}$ is within a range of 2-8 Torr, preferably the value of $U_{53}$ is within a range of 2-6 Torr;

wherein $U_{53} < U_{52} < U_{51}$.

In an embodiment of the present disclosure, the process of gradually reducing the furnace pressure of the monocrystal furnace includes:

when the equal-diameter length of the monocrystalline silicon is any a length within a range of less than 10% of a total length of the crystal rod, obtaining the value of the furnace pressure, U, of the monocrystal furnace; comparing the obtained value of the furnace pressure, U, of the monocrystal furnace with the preset value of the furnace pressure, $U_{51}$; and when $U > U_{51}$, reducing the furnace pressure, till $U \le U_{51}$, wherein the value of $U_{51}$ is within a range of 4-10 Torr;

when the equal-diameter length of the monocrystalline silicon is any a length within a range of greater than or equal to 10% of the total length of the crystal rod and less than 45% of the total length of the crystal rod, obtaining the value of the furnace pressure, U, of the monocrystal furnace; comparing the obtained value of the furnace pressure, U, of the monocrystal furnace with the preset value of the furnace pressure, $U_{52}$; and when $U > U_{52}$, reducing the furnace pressure, till $U \le U_{52}$, wherein the value of $U_{52}$ is within a range of 2-4 Torr; and

when the equal-diameter length of the monocrystalline silicon is any a length within a range of greater than or equal to 45% of the total length of the crystal rod, obtaining the value of the furnace pressure, U, of the monocrystal furnace; comparing the obtained value of the furnace pressure, U, of the monocrystal furnace with the preset value of the furnace pressure, $U_{53}$; and when $U > U_{53}$, reducing the furnace pressure, till $U \le U_{53}$, wherein the value of $U_{53}$ is within a range of 0-2 Torr.

In a preferred embodiment of the present disclosure, when the equal-diameter length of the monocrystalline silicon is any a length within the range of less than 10% of the total length of the crystal rod, the furnace pressure of the monocrystal furnace is controlled to be $U_{S501}$, and a value of $U_{S501}$ is within a range of 1-3 Torr;

when the equal-diameter length of the monocrystalline silicon is any a length within the range of greater than or equal to 10% of the total length of the crystal rod and less than 45% of the total length of the crystal rod, the furnace pressure of the monocrystal furnace is controlled to be $U_{S502}$, and a value of $U_{S502}$ is within a range of 0.3-2 Torr; and when the equal-diameter length of the monocrystalline silicon is any a length within the range of greater than or equal to 45% of the total length of the crystal rod, the furnace pressure of the monocrystal furnace is controlled to be $U_{S503}$, and a value of $U_{S503}$ is within a range of 0.01-0.3 Torr; wherein $U_{S503} < U_{S502} < U_{S501}$, wherein $U_{S501}$ is less than a preset value of the furnace pressure in any stage of seeding, shoulder expanding and shoulder turning.

Specifically, when the equal-diameter length of the monocrystalline silicon is any a length within the range of less than 10% of the total length of the crystal rod, obtaining the value of the furnace pressure, U, of the monocrystal furnace; comparing the obtained value of the furnace pressure, U, of the monocrystal furnace with a preset value of the furnace pressure, U ssi; and when $U > U_{S51}$, reducing the furnace pressure, till $U \leq U_{S51}$, wherein the value of U ssi is within a range of 1-3 Torr;

when the equal-diameter length of the monocrystalline silicon is any a length within the range of greater than or equal to 10% of the total length of the crystal rod and less than 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S52}$; and when $U > U_{S52}$, reducing the furnace pressure, till $U \leq U_{S52}$, wherein the value of $U_{S52}$ is within a range of 0.3-2 Torr; and when the equal-diameter length of the monocrystalline silicon is any a length within the range of greater than or equal to 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S53}$; and when $U > U_{S53}$, reducing the furnace pressure, till $U \leq U_{S53}$, wherein the value of $U_{S53}$ is within a range of 0.01-0.3 Torr; wherein $U_{S53} < U_{S52} < U_{S51}$, wherein, $U_{S51}$ is less than the preset value of the furnace pressure in any stage of seeding, shoulder expanding and shoulder turning.

In a preferred embodiment of the present disclosure, when the equal-diameter length of the monocrystalline silicon is any a length within the range of less than 10% of the total length of the crystal rod, controlling the furnace pressure of the monocrystal furnace to be $U_{S501}$, wherein $U_{S501}$ does not exceed 500 mTorr;

when the equal-diameter length of the monocrystalline silicon is any a length within the range of greater than or equal to 10% of the total length of the crystal rod and less than 45% of the total length of the crystal rod, controlling the furnace pressure of the monocrystal furnace to be $U_{S502}$, wherein $U_{S502}$ does not exceed 300 mTorr; and when the equal-diameter length of the monocrystalline silicon is any a length within the range of greater than or equal to 45% of the total length of the crystal rod, controlling the furnace pressure of the monocrystal furnace to be $U_{S503}$, wherein $U_{S503}$ does not exceed 100 mTorr; wherein $U_{S503} < U_{S502} < U_{S501}$, wherein $U_{S501}$ is less than the preset value of the furnace pressure in any stage of seeding, shoulder expanding and shoulder turning.

Specifically, when the equal-diameter length of the monocrystalline silicon is any a length within the range of less than 10% of the total length of the crystal rod, obtaining the value of the furnace pressure, U, of the monocrystal furnace; comparing the obtained value of the furnace pressure, U, of the monocrystal furnace with the preset value of the furnace pressure, $U_{S51}$; and when $U > U_{S51}$, reducing the furnace pressure, till $U \leq U_{S51}$, wherein $U_{S51}$ does not exceed 500 mTorr;

when the equal-diameter length of the monocrystalline silicon is any a length within the range of greater than or equal to 10% of the total length of the crystal rod and less than 45% of the total length of the crystal rod, obtaining the value of the furnace pressure, U, of the monocrystal furnace; comparing the obtained value of the furnace pressure, U, of the monocrystal furnace with the preset value of the furnace pressure, $U_{S52}$; and when $U > U_{S52}$, reducing the furnace pressure, till $U \leq U_{S52}$, wherein the value of $U_{S52}$ does not exceed 300 mTorr; and when the equal-diameter length of the monocrystalline silicon is any a length within the range of greater than or equal to 45% of the total length of the crystal rod, obtaining the value of the furnace pressure, U, of the monocrystal furnace; comparing the obtained value of the furnace pressure, U, of the monocrystal furnace with the preset value of the furnace pressure, $U_{S53}$; and when $U > U_{S53}$, reducing the furnace pressure, till $U \leq U_{S53}$, wherein the value of $U_{S53}$ does not exceed 100 mTorr; wherein $U_{S53} < U_{S52} < U_{S51}$, wherein, $U_{S51}$ is less than the preset value of the furnace pressure in any stage of seeding, shoulder expanding and shoulder turning.

In an embodiment of the present disclosure, the method further includes controlling the furnace pressure in the material-melting/feeding stage, the seeding stage, the shoulder-expanding stage and the shoulder-turning stage previous to the equal-diameter stage. Preferably, in the material-melting/feeding stage, the seeding stage, the shoulder-expanding stage, and the shoulder-turning stage, the furnace pressure does not exceed 18 Torr, and further preferably, the furnace pressure does not exceed 2 Torr.
For example, the furnace pressure in the material-melting/feeding stage, the seeding stage, the shoulder-expanding stage, and the shoulder-turning stage can be 0.001, 0.01, 0.02, 0.03, 0.04, 0.05, 0.06, 0.07, 0.08, 0.09, 0.1, 0.15, 0.2, 0.25, 0.3, 0.35, 0.4, 0.45, 0.5, 0.55, 0.6, 0.65, 0.7, 0.75, 0.8, 0.85, 0.9, 0.95, 1, 1.5, 2, 2.5, 3, 3.5, 4, 4.5, 5, 5.5, 6, 6.5, 7, 7.5, 8, 8.5, 9, 9.5, 10, 10.5, 11, 11.5, 12, 12.5, 13, 13.5, 14, 14.5, 15, 15.5, 16, 16.5, 17, 17.5, or 18 Torr, or any range among them.

In an embodiment of the present disclosure, at least in a time in the equal-diameter stage of the growth of the crystal, the furnace pressure U of the monocrystal furnace, a percentage L of the equal-diameter length of the crystal rod, the flow rate P of argon gas, and the frequency F of the vacuum pump meet $U = A*L + B*P + D*F + C$, wherein $1 \leq A \leq 10$, $0.01 \leq B \leq 0.02$, $-0.6 \leq D \leq -0.2$, and $10 \leq C \leq 25$.

A unit of the furnace pressure U of the monocrystal furnace is Torr, the percentage L of the equal-diameter length of the crystal rod is a percentage of a pulled length of the crystal rod to the total length of the crystal rod, a unit of the flow rate P of argon gas is SLPM, and a unit of the frequency F of the vacuum pump is Hz; wherein the furnace pressure meets $0.001$ Torr $\leq U \leq 15$ Torr, the flow rate of argon gas meets $0$ SLPM $< P \leq 70$ SLPM; and the frequency of the vacuum pump meets $20$ Hz $\leq F \leq 60$ Hz.

In an embodiment of the present disclosure, the monocrystalline silicon is doped with a dopant.

In a preferred embodiment of the present disclosure, the dopant is gallium.

A monocrystal furnace is a device that melts a polycrystalline material such as polycrystalline silicon, etc., by a graphite heater and grows a dislocation-free silicon monocrystal in an inert-gas environment by the Czochralski method. In a process of adopting the monocrystal furnace to produce a monocrystal of silicon, in order to meet a requirement of cell processing, a dopant is added during growth of crystalline silicon to meet a requirement of an electrical property. Group V elements are commonly adopted as N-type dopants for the monocrystalline silicon, and mainly include phosphorus, arsenic, and antimony. Group III elements are commonly adopted as P-type dopants for the monocrystalline silicon, and mainly include boron, aluminum, and gallium. However, in an actual process of producing of a silicon monocrystal by adopting the monocrystal furnace, due to different diffusion rates of doped elements of the above-mentioned dopants in two phases of solid and liquid at a growth interface of the silicon monocrystal, a longitudinal resistivity of a crystal of a pulled silicon monocrystal is inconsistent, that is, the resistivity of the crystal of the pulled silicon monocrystal gradually decreases from a head to a tail thereof. Especially for a N-type silicon monocrystal, a difference between the resistivities of the head and the tail of the crystal of the silicon monocrystal is particularly large. For example, the resistivity of semiconductor-grade monocrystalline silicon currently produced degrades seriously from the head to the tail thereof. The resistivity of the head of the semiconductor-grade monocrystalline silicon is about 38 $\Omega \cdot$cm, the resistivity of a middle of the semiconductor-grade monocrystalline silicon is about 32 $\Omega \cdot$cm, and the resistivity of the tail thereof is about 20 $\Omega \cdot$cm.

Among them, since a segregation coefficient (0.8) of boron in silicon is close to 1, the resistivity of a prepared boron-doped silicon crystal is distributed relatively uniformly. However, a phenomenon of the light-induced degradation will occur after a cell prepared from a boron-doped silicon wafer is adopted, which reduces conversion efficiency of the cell. At present, it is mainly believed to be related to boron-oxygen complexes formed by boron atoms doped and oxygen atoms in the crystalline silicon under sunlight irradiation.

Formation of the boron-oxygen complex can be avoided by doping gallium, to suppress the phenomenon of the light-induced degradation. However, a relatively small segregation coefficient (0.008) of gallium leads to a wide range of the resistivity of obtained crystalline silicon, especially a part of the crystalline silicon (a tail of Czochralski monocrystalline silicon, a directionally-solidified polycrystalline-silicon block, or a head of the monocrystalline silicon), lastly grown during a process of the growth of the crystal, has a relatively high doping concentration of gallium, has a relatively low resistivity, and has a too small region where the resistivity thereof meets a requirement (1-3 $\Omega \cdot$cm), which leads a yield for preparing high-efficiency solar cells is only 50%-60%, such that cost of growing the crystalline silicon is too high.

In the technical solution of the present disclosure, a crystal-pulling process of a low-pressure furnace is adopted, even reaches a millitorr level. When the furnace pressure is close to a saturated-vapor pressure of gallium atoms, 0.01 Torr, a volatilization rate of gallium atoms is accelerated. At this time, all of the saturated-vapor pressures of elements including such as P, As, Zn, Mg, Ca, Mn, etc., are > 0.01 Torr, and these elements will volatilize quickly under this condition, so impurities in the molten silicon will decrease rapidly under this condition. With rapid volatilization of gallium atoms, gallium atoms in the molten silicon decrease rapidly, which can suppress a degradation rate of the resistivity of the crystal rod, increase the length of the crystal rod whose resistivity is within an effective range, and improve uniformity of the resistivity during the crystal-pulling process, such that fluctuation of an change range of the resistivity is small, which is controlled to be within $\pm 0.1$, the minority-carrier lifetime is greatly improved, which may be above 10%, and the resistivity is distributed uniformly, so that a very good technical effect can be achieved.

A term "minority-carrier lifetime" refers to an average lifetime of non-equilibrium minority carriers, which is called a lifetime of the minority carrier, or minority-carrier lifetime for short. The minority-carrier lifetime of a crystalline-silicon solar cell is one of important parameters for evaluating the solar cell, which is closely related to a material integrity and an impurity content. The minority-carrier lifetime reflects a recombination speed of photogenerated carriers on a surface and in a matrix of the solar cell, that is, reflects a utilization degree of the photogenerated carriers.

A term "oxygen content" refers to an oxygen concentration in the crystal, which is one of core parameters of crystal quality. Oxygen is mainly from the quartz crucible. In a melted state, the molten silicon reacts with the quartz crucible to produce SiO to be melt in the silicon melt. During the crystal-pulling process, most of the SiO in the silicon melt is freely volatilized through a surface of the melt, a part of the SiO enters the monocrystal due to segregation, and a part the SiO remains in the silicon melt. At beginning of an equal-diameter process, there is more silicon melt in the crucible, and a contact area between the silicon melt and the crucible is the largest, so the oxygen content is relatively high at this time. After the oxygen content is higher than a certain degree, rings of oxygen deficiency will be formed, which will form thermal donors or oxygen precipitation during a cooling process of the crystal, such that the minority-carrier lifetime or the resistivity will ultimately be affected.

The oxygen content/the minority-carrier lifetime: a technical parameter that characterizes intrinsic quality of the monocrystalline silicon (in the field of photovoltaics, generally, the lower the oxygen content, the better, and the higher the minority-carrier lifetime, the better).

The Czochralski monocrystalline silicon: a growth technology for growing the monocrystalline silicon. Different conductivity types of the monocrystalline silicon need to be doped with different elements. For example, boron (B) is doped for P-type monocrystalline silicon, and phosphorus (P) is doped for N-type monocrystalline silicon.

A resistivity formula is expressed as $\rho = 1/qp\mu$ (wherein $\rho$ is the resistivity, q is quantity of a unit charge, p is a hole concentration in P-type silicon or an electron concentration in N-type silicon, and $\mu$ is a mobility of majority carriers). In uncompensated silicon, a relationship between $\mu$ and p in this formula has been clarified by a large number of previous experiments, and it can be directly converted into a carrier concentration in a silicon crystal by measuring the resistivity thereof. However, in a silicon crystal with a compensation effect, total concentrations of a donor impurity and an acceptor impurity and a compensation degree will cause the mobility to deviate from an original $\mu$-p relationship, and this deviation is difficult to be measured in advance.

A term "length of the crystal rod when the resistivity of the tail is 0.45" refers to the length of a pulled crystal rod when the resistivity of the tail of the crystal rod is 0.45 $\Omega$.cm.

A term "pulled-out ratio when the resistivity of the tail is 0.45" means a ratio of a weight of a crystal rod pulled out to an initial total charge of a crucible when the resistivity of the tail of the crystal rod is 0.45 $\Omega$.cm.

The present disclosure can be further described in detail through the embodiments, which are only adopted to illustrate the present disclosure and do not limit a scope of the present disclosure. An embodiment section of the present disclosure consists of "implementations", "contrast examples", "comparison examples", and "experimental examples".

The embodiments of the present disclosure will be described in detail below. While the embodiments of the present disclosure are shown herein, it should be understood that the present disclosure may be implemented in various forms and should not be limited by the embodiments set forth herein. Rather, these the embodiments are provided for a purpose that the present disclosure will be more thoroughly understood, and the scope of the present disclosure will be fully conveyed to those skilled in the art.

Implementation 1

A crystal-growth process (CZ method) of the monocrystalline silicon doped with gallium is as follows:
In the material-melting stage, keeping the furnace pressure being 11-15 Torr (a pressure unit, 1 Torr is 1 mmHg), and the flow rate of argon gas being 100 SLPM (stard liter per minute, that is, a standard liter per minute for a flow value).

In the stages of the temperature adjustment, the seeding and the shoulder expanding, keeping the furnace pressure being 11-15 Torr.

In the equal-diameter stage, the furnace pressure is gradually reduced as the length of the crystal rod increases, down to 0-10 Torr. The whole process of the equal-diameter stage is automatically controlled by the system, and the furnace pressure is controlled by adjusting the flow rate of argon gas and/or a frequency of a dry pump. Parameters thereof are as shown in table 1 below:

Table 1

| Equal-diameter length (mm) | Furnace pressure (Torr) |
| --- | --- |
| 0 | 11-15 |
| 150 | 10-14 |
| 250 | 8-12 |
| 350 | 6-10 |
| 600 | 4-8 |
| 1500 | 3-7 |

(continued)

| Equal-diameter length (mm) | Furnace pressure (Torr) |
|---|---|
| 2500 | 2-6 |
| 3250 | 2-6 |
| 3400 | 2-6 |

In the ending stage, the furnace pressure gradually return to a normal level.

Then, entering a next cycle.

The dry pump is adopted to adjust the furnace pressure. In order to protect the dry pump, an upper limit of the frequency of the dry pump is set to avoid a full-load operation affecting a service life thereof.

Contrast example 1

A difference between the contrast example 1 and the implementation 1 is only in that parameters such as the furnace pressure, etc., in a following table are different, and data of the furnace pressure in this contrast example is as shown in contrast table 1 below:

Contrast table 1

| Equal-diameter length (mm) | Furnace pressure (Torr) |
|---|---|
| 0 | 70 |
| 150 | 50-60 |
| 250 | 40-50 |
| 350 | 30-40 |
| 600 | 20-30 |
| 1500 | 15-20 |
| 2500 | 10-15 |

Comparison example 1

The resistivity of the head and an effective resistivity of the tail of the crystal rod of the monocrystalline silicon with the length of 2500 mm obtained in the implementation 1, and that in the contrast example 1 are compared as shown in comparison table 1 below:

Comparison table 1

| | Implementation 1 | Contrast example 1 |
|---|---|---|
| Resistivity of the head of the crystal rod | 1.01 | 1.01 |
| Effective resistivity of the tail of the crystal rod | 0.50 | 0.46 |

Referring to the above comparison table 1, under a condition that the resistivities of the heads of the crystal rods of the monocrystalline silicon with the length of 2500 mm obtained are the same, the effective resistivity of the tail of the crystal rod in the implementation 1 is higher than that in the contrast example 1.

Implementation 2

The crystal-growth process (CZ method) of the monocrystalline silicon doped with gallium is as follows:

In the material-melting stage, the temperature-adjustment stage, the seeding stage and the shoulder-expanding stage of the growth of the crystal, keeping the furnace pressure of the monocrystal furnace being 11-15 Torr, and the flow rate of argon gas being 100 SLPM.

In the equal-diameter stage, a percentage of the equal-diameter length of the crystal rod and the furnace pressure of the monocrystal furnace are controlled according to following table 2, and the furnace pressure is controlled to correspond to the percentage of the equal-diameter length of the crystal rod by adjusting the flow rate of argon gas and/or the frequency of the dry pump.

Table 2

| Percentage of the equal-diameter length | Furnace pressure (Torr) |
|---|---|
| 0% | 10 |
| 4% | 7 |
| 7% | 5 |
| 10% | 4 |
| 18% | 3 |
| 44 % | 2 |
| 74% | 2 |
| 96% | 2 |
| 100% | 2 |

Contrast example 2

A difference between the contrast example 2 and the implementation 2 is only in that parameters in a following table are different, and the data such as the furnace pressure, etc., in the contrast example 2 is as shown in contrast table 2 below:

Contrast table 2

| Percentage of the equal-diameter length | Furnace pressure (Torr) |
|---|---|
| 0% | 70 |
| 4% | 70 |
| 7% | 70 |
| 10% | 70 |
| 18% | 68 |
| 44% | 58 |
| 74% | 40 |
| 96% | 20 |
| 100% | 10 |

Implementation 3

The crystal-growth process (CZ method) of the monocrystalline silicon doped with gallium is as follows:
In the material-melting stage, the temperature-adjustment stage, the seeding stage and the shoulder-expanding stage of the growth of the crystal, keeping the furnace pressure of the monocrystal furnace being 11-15 Torr, and the flow rate of argon gas being 100 SLPM.
In the equal-diameter stage, according to a following table 3, the percentage L of the equal-diameter length of the crystal rod, the furnace pressure U of the monocrystal furnace, the flow rate P of argon gas, and the frequency F of the dry pump are controlled to correspond to each other, and to be kept always meeting $U = A*L + B*P + D*F + C$,
[0070]    wherein $5 \leq A \leq 10$, $0.01 \leq B \leq 0.02$, $-0.6 \leq D \leq -0.2$, and $15 \leq C \leq 20$.
Among them, a value of the furnace pressure is within a range of $2\ \text{Torr} \leq U \leq 10\ \text{Torr}$, a value of the flow rate of argon gas is within a range of $50\ \text{SLPM} \leq P \leq 70\ \text{SLPM}$, and a value of the frequency of the dry pump is within a range of $20\ \text{Hz} \leq F \leq 60\ \text{Hz}$. Relevant parameters in this implementation are as shown in table 3 below:

Table 3, the parameters in the equal-diameter stage of the growth of the crystal

| Percentage of the equal-diameter length | Furnace pressure (Torr) | Flow rate of argon gas (SLPM) | Frequency of the dry pump (Hz) |
|---|---|---|---|
| 0% | 10 | 70 | 20 |
| 4% | 7 | 70 | 20 |
| 7% | 5 | 70 | 30 |
| 10% | 4 | 60 | 30 |
| 18% | 3 | 60 | 35 |
| 44% | 2 | 60 | 35 |
| 74% | 2 | 50 | 40 |
| 96% | 2 | 50 | 50 |
| 100% | 2 | 50 | 60 |

Comparison example 2

The resistivity of the head and the effective resistivity of the tail of the crystal rod of the monocrystalline silicon with the percentage of 100% obtained in the implementation 2, and that in the implementation 3 and the contrast example 2 are compared as shown in comparison table 2 below:

Comparison table 2

| | Implementation 2 | Implementation 3 | Contrast example 2 |
|---|---|---|---|
| Resistivity of the head of the crystal rod | 1.01 | 1.01 | 1.01 |
| Effective resistivity of the tail of the crystal rod | 0.50 | 0.49 | 0.46 |

Referring to the above comparison table 2, under a condition that the resistivities of the heads of the crystal rods of the monocrystalline silicon with the percentage of 100% obtained are the same, the effective resistivities of the tails of the crystal rods in the implementation 2 and the implementation 3 are higher than that in the contrast example 2.

Implementation 4

The crystal-growth process (CZ method) of the monocrystalline silicon doped with gallium is as follows:

In the material-melting/feeding stage, the seeding stage, the shoulder-expanding stage, and the shoulder-turning stage of the growth of the crystal, keeping the furnace pressure of the monocrystal furnace being 5-11 Torr, the flow rate of argon gas being 70 SLPM, and the frequency of the dry pump being 20 Hz.

In the equal-diameter stage, according to a following table 4, the percentage L of the equal-diameter length of the crystal rod, the furnace pressure U of the monocrystal furnace, the flow rate P of argon gas, and the frequency F of the dry pump are controlled to correspond to each other, and to be kept always meeting $U = A*L + B*P + D*F + C$, wherein $1 \leq A \leq 10$, $0.01 \leq B \leq 0.02$, $-0.6 \leq D \leq -0.2$, and $10 \leq C \leq 25$.

Among them, the value of the furnace pressure is within a range of 0.01 Torr $\leq U \leq$ 4 Torr, the value of the flow rate of argon gas is within a range of 5 SLPM $\leq P \leq$ 50 SLPM, and the value of the frequency of the dry pump is within a range of 20 Hz $\leq F \leq$ 60 Hz. The relevant parameters in this implementation are as shown in table 4 below:

Table 4, the parameters in the equal-diameter stage of the growth of the crystal

| Percentage of the equal-diameter length | Furnace pressure (Torr) | Flow rate of argon gas (SLPM) | Frequency of the dry pump (Hz) |
|---|---|---|---|
| 1% | 4 | 50 | 20 |
| 4% | 2 | 40 | 25 |
| 7% | 1.5 | 30 | 30 |

(continued)

| Percentage of the equal-diameter length | Furnace pressure (Torr) | Flow rate of argon gas (SLPM) | Frequency of the dry pump (Hz) |
|---|---|---|---|
| 10% | 1 | 20 | 40 |
| 17% | 0.8 | 15 | 40 |
| 45% | 0.3 | 12 | 50 |
| 73% | 0.08 | 10 | 54 |
| 85% | 0.03 | 7 | 56 |
| 100% | 0.01 | 5 | 58 |

Implementation 5

The crystal-growth process (CZ method) of the monocrystalline silicon doped with gallium is as follows:
In the material-melting/feeding stage, the seeding stage, the shoulder-expanding stage, and the shoulder-turning stage of the growth of the crystal, keeping the furnace pressure of the monocrystal furnace being 5-11 Torr, the flow rate of argon gas being 70 SLPM, and the frequency of the dry pump being 20 Hz.
In the equal-diameter stage, according to a following table 5, the percentage L of the equal-diameter length of the crystal rod, the furnace pressure U of the monocrystal furnace, the flow rate P of argon gas, and the frequency F of the dry pump are controlled to correspond to each other, and to be kept always meeting $U = A*L + B*P + D*F + C$, wherein $1 \leq A \leq 10$, $0.01 \leq B \leq 0.02$, $-0.6 \leq D \leq -0.2$, and $10 \leq C \leq 25$.
Among them, the value of the furnace pressure is within a range of $0.01 \text{ Torr} \leq U \leq 1.5 \text{ Torr}$, the value of the flow rate of argon gas is within a range of $5 \text{ SLPM} \leq P \leq 35 \text{ SLPM}$, and the value of the frequency of the dry pump is within a range of $20 \text{ Hz} \leq F \leq 60 \text{ Hz}$. The relevant parameters in this implementation are as shown in table 5 below:

Table 5, the parameters in the equal-diameter stage of the growth of the crystal

| Percentage of the equal-diameter length | Furnace pressure (Torr) | Flow rate of argon gas (SLPM) | Frequency of the dry pump (Hz) |
|---|---|---|---|
| 1% | 1.5 | 35 | 35 |
| 4% | 1.2 | 30 | 35 |
| 7% | 1 | 20 | 40 |
| 10% | 1 | 20 | 40 |
| 17% | 0.8 | 15 | 40 |
| 45% | 0.3 | 12 | 50 |
| 73% | 0.08 | 10 | 54 |
| 85% | 0.03 | 7 | 56 |
| 100% | 0.01 | 5 | 58 |

Implementation 6

The crystal-growth process (CZ method) of the monocrystalline silicon doped with gallium is as follows:
In the material-melting/feeding stage, the seeding stage, the shoulder-expanding stage, and the shoulder-turning stage of the growth of the crystal, keeping the furnace pressure of the monocrystal furnace being 5-11 Torr, the flow rate of argon gas being 70 SLPM, and the frequency of the dry pump being 20 Hz.
In the equal-diameter stage, according to a following table 6, the percentage L of the equal-diameter length of the crystal rod, the furnace pressure U of the monocrystal furnace, the flow rate P of argon gas, and the frequency F of the dry pump are controlled to correspond to each other, and to be kept always meeting $U = A*L + B*P + D*F + C$, wherein $1 \leq A \leq 10$, $0.01 \leq B \leq 0.02$, $-0.6 \leq D \leq -0.2$, and $10 \leq C \leq 25$.
Among them, the value of the furnace pressure is within a range of $1 \text{ mTorr} \leq U \leq 500 \text{ mTorr}$, the value of the flow rate of argon gas is within a range of $5 \text{ SLPM} \leq P \leq 35 \text{ SLPM}$, and the value of the frequency of the dry pump is within a range of 20 Hz ≤ F ≤ 60 Hz. The relevant parameters in this implementation are as shown in table 6 below:

Table 6, the parameters in the equal-diameter stage of the growth of the crystal

| Percentage of the equal-diameter length | Furnace pressure (mTorr) | Flow rate of argon gas (SLPM) | Frequency of the dry pump (Hz) |
|---|---|---|---|
| 1% | 500 | 35 | 35 |
| 4% | 420 | 30 | 35 |
| 7% | 380 | 20 | 40 |
| 10% | 300 | 20 | 40 |
| 17% | 200 | 15 | 40 |
| 45% | 100 | 12 | 50 |
| 73% | 50 | 10 | 54 |
| 85% | 10 | 7 | 56 |
| 100% | 1 | 5 | 58 |

Implementation 7

Comparing with the implementation 5, a difference lies in that the furnace pressure of the monocrystal furnace in the material-melting/feeding stage, seeding stage, shoulder-expanding stage, and shoulder-turning stage of the growth of the crystal in the implementation 7 is kept not exceeding 2 Torr, and other parameters are the same as that in the implementation 5. In the equal-diameters stage, the parameters in the implementation 7 are the same as that in the implementation 5.

Implementation 8

Comparing with the implementation 6, a difference lies in that the furnace pressure of the monocrystal furnace in the material-melting/feeding stage, seeding stage, shoulder-expanding stage of the growth of the crystal, and shoulder-turning stage of the growth of the crystal in the implementation 8 is kept not exceeding 2 Torr, and other parameters are the same as that in the implementation 6. In the equal-diameters stage, the parameters in the implementation 8 are the same as that in the implementation 6.

Experimental example 1

Contrast conditions: a requirement for the resistivity: 0.4-1.0; a size of a thermal field: 26 inches; a charge of a single furnace: 330kg; the furnace pressure: 11 Torr; the flow rate of argon gas: 80L/min; and a size of a round rod: 228 mm.
Experimental conditions: the requirement for the resistivity: 0.4-1.0; the size of the thermal field: 26 inches; the charge of the single furnace: 330kg; the furnace pressure < 1.5 Torr; the flow rate of argon gas: 5-70L/min; and the size of the round rod: 228 mm.
Characterization method: the resistivity: detected by a four-probe method; the oxygen content: detected by a Fourier-transform-infrared method; and the minority-carrier lifetime: detected by a BCT400 device.
Other experimental conditions are carried out according to usual experimental conditions in the field.

Comparison example 3

The resistivity of the head and the effective resistivity of the tail of the crystal rod of the monocrystalline silicon with the percentage of 100% obtained in the implementation 2, and that in the implementations 4-8 are compared as shown in comparison table 3 below:

Comparison Table 3

| | Implementation 4 | Implementation 5 | Implementation 6 | Implementation 7 | Implementation 8 | Implementation 2 |
|---|---|---|---|---|---|---|
| Resistivity of the head of the crystal rod | 1.01 | 1.01 | 1.01 | 1.01 | 1.01 | 1.01 |
| Length of the crystal rod when the resistivity of the tail is 0.45 (mm) | 2450 | 2550 | 2800 | 2600 | 2950 | 2150 |
| Pulled-out ratio when the resistivity of the tail is 0.45 | 70.63% | 73.52% | 80.73% | 74.96% | 85.00% | 61.99% |
| Minority-carrier lifetime when the length of the crystal rod is 100% | $335\mu S$ | $367\mu S$ | $408\mu S$ | $385\mu S$ | $421\mu S$ | $280\mu S$ |
| (%) | | | | | | |

As can be seen from the comparison table 3, it can be seen from the implementations 4-6 that the furnace pressure of the monocrystal furnace is kept being 5-11 Torr in the material-melting/feeding stage, seeding stage, shoulder-expanding stage, and shoulder-turning stage. While in the equal-diameter stage, the lower the furnace pressure is controlled, the longer the length of the crystal rod when the resistivity of the tail is 0.45, and the higher the pulled-out ratio when the resistivity of the tail is 0.45, the lower the minority-carrier lifetime when the length of the crystal rod is 100%.

It can be seen from the implementation 7 and the implementation 5, and the implementation 8 and the implementation 6, that under a condition that the furnace pressures in the equal-diameter stage are the same, when the furnace pressure of the monocrystal furnace is kept not exceeding 2 Torr in the material-melting/feeding stage, seeding stage, shoulder-expanding stage, and shoulder-turning stage, the longer the length of the crystal rod when the resistivity of the tail is 0.45, and the higher the pulled-out ratio when the resistivity of the tail is 0.45, the lower the minority-carrier lifetime when the length of the crystal rod is 100%, that is, the better the technical effect.

In the prior art, a relatively high fixed furnace pressure is usually adopted to pull a gallium-doped monocrystal, and a degradation rate of the resistivity in its axial direction is constant. In the present disclosure, by controlling the parameters such as the furnace pressure, etc., in the equal-diameter stage of the growth of the crystal, the crystal-pulling process of changing the furnace pressure in the equal-diameter stage is realized, and volatilization of gallium is promoted, thereby reducing its the degradation rate of the resistivity thereof and increasing a length thereof with the effective resistivity.

A theoretical model, on which the disclosure is based, is as follows:

$$L = \frac{(\rho_T - \rho_W) \times 0.5 L_0}{\rho_T - \left[\frac{1.305 \times 10^{16}}{C(0)E(1-0.5)^{K-1}} + \frac{1.133 \times 10^{17}}{C(0)E(1-0.5)^{K-1}\left[1 + (2.58 \times 10^{-19} \times C(0)E(1-0.5)^{K-1})^{-0.737}\right]}\right]},$$

and

$$E = \left[\frac{(1-0.5)\left(\frac{Z_1}{Z_0}-1\right)}{\frac{Z_1}{Z_0}-(1-0.5)}\right]^{\frac{\kappa T^{0.75} p_{Bx}^0 (1-m^2)}{K C_{Si} m^2 Z_1 P R}},$$

among them: L is the percentage of the pulled length to the total length of the crystal rod, that is, the percentage of equal-diameter length;

$\rho_T$ is an upper limit of a controlled resistivity, that is, the resistivity of the head of the crystal rod;

$\rho_W$ is a lower limit of a controlled resistivity, that is, the effective resistivity of the tail of the crystal rod;

$L_0$ is the length of the crystal rod that is pulled out by all silicon liquid;

C(0) is a concentration of gallium in the silicon liquid at beginning of the equal-diameter stage;

K is the segregation coefficient of gallium;

E is a volatility coefficient;

Zi is the height of the crucible;

$Z_0$ is a height of initial silicon liquid;

$\kappa$ is a gas-diffusion-coefficient constant;

T is a temperature of the silicon liquid (K);

$P_{Bx}^0$ is a vapor pressure of gallium;

m is a ratio of the diameter of the crystal rod to an inner diameter of the crucible;

K is a Boltzmann constant;

$C_{Si}$ is a concentration of silicon atoms in the silicon liquid;

P is an air pressure in the furnace; and

R is a rate of the growth of the crystal.

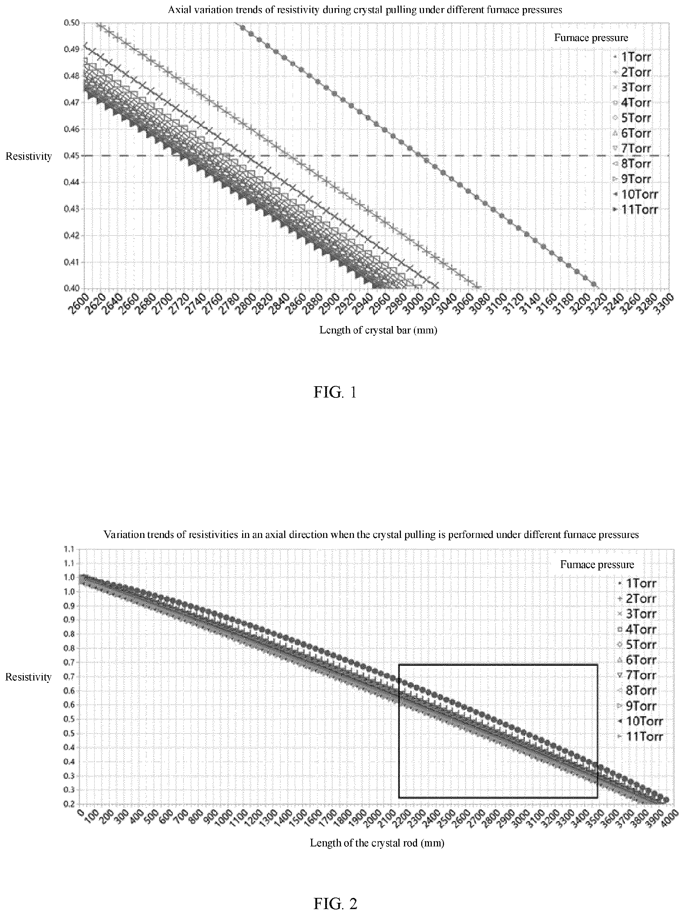

In a condition that the resistivities of the heads are equal, the lower the furnace pressure, the lower a slope of degradation of the resistivity in an axial direction. By simulating degradation trends of the resistivities in the axial direction under different furnace pressures according to the above theoretical model, it can be seen, as shown in FIG. 1 and FIG. 2, the length of the pulled crystal rod when the resistivity is 0.45 under the furnace pressure of 2 Torr is increased by about 130 mm than that under the furnace pressure of 11 Torr. Therefore, it can be proved theoretically that the crystal pulling under the low furnace pressure is feasible to relieve the degradation of the resistivity of the gallium-doped monocrystal in the axial direction and increase the length thereof with the effective resistivity.

According to the above theoretical model, by controlling process parameters in the equal-diameter stage by an equal-diameter furnace pressure, the gallium-doped monocrystal can be pulled out stably under a condition of low furnace pressure.

In the crystal-pulling method related to the present disclosure, the method optionally includes following steps: S1, in the material-melting stage, keeping a normal furnace pressure and flow rate of argon gas. Typically, the normal furnace pressure is 11-15 Torr and the flow rate of argon gas is 40-100 SPLM. The material-melting power is 50-90 kw. After the block of the material in the crucible is completely melted into liquid, the material-melting stage ends. The seed crystal is lowered to a height of temperature adjustment.

S2, in the stage of temperature adjustment, seeding and shoulder expanding, keeping the normal furnace pressure. The seed crystal is immersed in the silicon liquid, till four crystal points appear, indicating that fusing is successful, and the seed crystal can be raised for seeding. A seeding length is generally to be 100-250 mm, a purpose of which is to exclude dislocations. After the seeding is completed, the shoulder-expanding stage is entered, the diameter of the crystal gradually increases to form a conical shoulder, till the diameter reaches the equal diameter, then the shoulder turning is performed. After the shoulder turning is completed, the equal-diameter stage is entered.

S3, in the equal-diameter stage, gradually reducing the furnace pressure as the length of the crystal rod increases, generally down to 0-10 Torr. Other crystal-pulling parameters such as a power of the vacuum pump, etc., are synchronously adjusted. The whole process of the equal-diameter stage is automatically controlled by the system.

S4, in the ending stage, the furnace pressure and other parameters gradually return to normal levels. When the equal-diameter length reaches a requirement, exiting the equal-diameter stage and gradually lifting the crystal rod out of the liquid surface.

S5, in the material-melting stage, keeping the normal furnace pressure.

......

The above steps are cycled repeatedly, till the production of the furnace is finished.

Among them, the steps S1, S2, and S3 can be carried out in a charging stage, and the step S4 can be carried out in the ending stage.

Compared with the prior art, a beneficial effect of an aspect of the present disclosure lies in that: by controlling the frequency of the dry pump and/or the flow of argon gas in the equal-diameter stage, the gallium-doped monocrystal can be pulled stably under the lower furnace pressure, which may effectively reduce the degradation of the resistivity of the gallium-doped monocrystal in the axial direction, and increase the length of the crystal rod whose resistivity is within the effective range.

Implementation 9

The crystal-growth process (CZ method) of the monocrystalline silicon doped with 0.014% (a mass percentage) of gallium is as follows:

S1, in the material-melting stage, keeping the normal furnace pressure and flow rate of argon gas. The normal furnace pressure is 11-15 Torr (the pressure unit, 1 Torr is 1 mmHg), and the flow rate of argon gas is 100 SLPM (the stard liter per minute, that is, the standard liter per minute for the flow value).

S2, in the stages of the temperature adjustment, the seeding and the shoulder expanding, keeping the normal furnace pressure.

S3, in the equal-diameter stage, the furnace pressure is gradually reduced as the length of the crystal rod increases, down to 0-10 Torr. The whole process of the equal-diameter stage is automatically controlled by the system. Parameters thereof are as shown in table 7 below:

Table 7

| Equal-diameter length (mm) | Furnace pressure (Torr) | Flow rate of argon gas (SLPM) |
| --- | --- | --- |
| 0 | 11-15 | 50-70 |
| 150 | 10-14 | 50-70 |
| 250 | 8-12 | 50-70 |
| 350 | 6-10 | 50-70 |
| 600 | 4-8 | 50-70 |
| 1500 | 3-7 | 50-70 |

(continued)

| Equal-diameter length (mm) | Furnace pressure (Torr) | Flow rate of argon gas (SLPM) |
|---|---|---|
| 2500 | 2-6 | 50-70 |
| 3250 | 2-6 | 50-70 |
| 3400 | 2-6 | 50-70 |

S4, in the ending stage, the furnace pressure gradually returns to the normal level.

S5, in the material-melting stage, keeping the normal furnace pressure.

The dry pump is adopted to adjust the furnace pressure. In order to protect the dry pump, the upper limit of the frequency of the dry pump is set to avoid the full-load operation affecting the service life thereof.

Implementation 10

A difference between the implementation 10 and the implementation 9 is only in that the flow rates of argon gas in the monocrystal furnace therein are different. Data of the flow rate of argon gas in the implementation 10 is shown as shown in table 8 below:

Table 8

| Equal-diameter length (mm) | Furnace pressure (Torr) | Flow rate of argon gas (SLPM) |
|---|---|---|
| 0 | 11-15 | 71-100 |
| 150 | 10-14 | 71-100 |
| 250 | 8-12 | 71-100 |
| 350 | 6-10 | 71-100 |
| 600 | 4-8 | 71-100 |
| 1500 | 3-7 | 71-100 |
| 2500 | 2-6 | 71-100 |
| 3250 | 2-6 | 71-100 |
| 3400 | 2-6 | 71-100 |

Contrast example 3

A difference between the contrast example 3 and the implementation 9 is only in that parameters such as the furnace pressure, etc., in a following table are different, and the data of the furnace pressure in this contrast example is as shown in contrast table 3 below:

Contrast table 3

| Equal-diameter length (mm) | Furnace pressure (Torr) | Flow rate of argon gas (SLPM) |
|---|---|---|
| 0 | 70 | 50-80 |
| 150 | 50-60 | 50-80 |
| 250 | 40-50 | 50-80 |
| 350 | 30-40 | 50-80 |
| 600 | 20-30 | 50-80 |
| 1500 | 15-20 | 50-80 |
| 2500 | 10-15 | 50-80 |

Comparison example 4

The resistivity of the head and the effective resistivity of the tail of the crystal rod of the monocrystalline silicon with the length of 2500 mm obtained in the contrast example 1, and that in the implementation 9 and the implementation 10 are compared as shown in comparison table 4 below:

Comparison table 4

| | Implementation 1 | Implementation 2 | Contrast example 1 |
|---|---|---|---|
| Resistivity of the head of the crystal rod | 1.01 | 1.01 | 1.01 |
| Effective resistivity of the tail of the crystal rod | 0.50 | 0.48 | 0.46 |

Referring to the above comparison table 4, under the condition that the resistivities of the heads of the crystal rods of the monocrystalline silicon with the length of 2500 mm obtained are the same, the effective resistivities of the tails of the crystal rods in both the implementation 9 and the implementation 9 are higher than that in the contrast example 1.

Implementation 11

The crystal-growth process (CZ method) of the monocrystalline silicon doped with 0.014% (the mass percentage) of gallium is as follows:

S1, in the material-melting stage, the temperature-adjustment stage, the seeding stage and the shoulder-expanding stage of the growth of the crystal, keeping the furnace pressure of the monocrystal furnace being 11-15 Torr, and the flow rate of argon gas being 100 SLPM.

S2, in the equal-diameter stage, at a moment when the percentage of the equal-diameter length of the crystal rod reaches a preset value as shown in the Table 3', the furnace pressure corresponding to the moment is obtained through a detected result of an inside of the monocrystal furnace.

S3, according to the contrast table (Table 3') of the percentage L of the equal-diameter length of the crystal rod and the corresponding preset furnace pressure$_0$ U of the monocrystal furnace in the equal-diameter stage, a size of the preset furnace pressure $U_5$ of the monocrystal furnace is compared with a size of the detected furnace pressure U. When $U_5 \geq U$, keeping a frequency $F_1$ of the dry pump, and keeping the flow rate of argon gas being 70 SLPM. When $U_0 < U$, increasing the frequency $F_1$ of the dry pump, gradually increasing the frequency of the dry pump, up to $F_2$, then detecting the furnace pressure U of the monocrystal furnace, and comparing the size of U and the size of $U_5$ again. When $U_5 \geq U$, keeping the frequency of the dry pump being F2. When $U_5 < U$, continue to increase the frequency of the dry pump, till the furnace pressure of the monocrystal furnace in the equal-diameter stage is less than or equal to $U_5$.

Preferably, the preset furnace pressure of the monocrystal furnace is selected within a range of $2\ \text{Torr} \leq U_5 < 10\ \text{Torr}$, and the frequency of the dry pump is within a range of $20\ \text{Hz} \leq F < 60\ \text{Hz}$.

The relevant parameters in this implementation are as shown in table 9 below:

Table 9

| Percentage of the equal-diameter length | Preset furnace pressure $U_5$ of the monocrystal furnace (Torr) | Flow rate of argon gas (SLPM) |
|---|---|---|
| 0% | 10 | 70 |
| 4% | 7 | 70 |
| 7% | 5 | 70 |
| 10% | 4 | 70 |
| 18% | 3 | 70 |
| 44% | 2 | 70 |
| 74% | 2 | 70 |
| 96% | 2 | 70 |

(continued)

| Percentage of the equal-diameter length | Preset furnace pressure $U_5$ of the monocrystal furnace (Torr) | Flow rate of argon gas (SLPM) |
|---|---|---|
| 100% | 2 | 70 |

S4, in the ending stage, the furnace pressure and other parameters gradually return to value ranges previous to the equal-diameter stage.

Implementation 12

The crystal-growth process (CZ method) of the monocrystalline silicon doped with 0.014% (the mass percentage) of gallium is as follows:
S1, in the material-melting stage, the temperature-adjustment stage, the seeding stage and the shoulder-expanding stage of the growth of the crystal, keeping the furnace pressure of the monocrystal furnace being 11-15 Torr, and the flow rate of argon gas being 100 SLPM.
S2, in the equal-diameter stage, the percentage of the equal-diameter length of the crystal rod, the furnace pressure of the monocrystal furnace, the flow rate of argon gas, and the frequency of the dry pump are controlled according to following table 10, to make them correspond to each other.

Table 10

| Percentage of the equal-diameter length | Furnace pressure (Torr) | Flow rate of argon gas (SLPM) | Frequency of the dry pump (Hz) |
|---|---|---|---|
| 0% | 10 | 70 | 20 |
| 4% | 7 | 70 | 20 |
| 7% | 5 | 70 | 30 |
| 10% | 4 | 70 | 40 |
| 18% | 3 | 70 | 50 |
| 44% | 2 | 70 | 55 |
| 74% | 2 | 70 | 58 |
| 96% | 2 | 70 | 55 |
| 100% | 2 | 70 | 58 |

Contrast example 4

A difference between the contrast example 4 and the implementation 12 is only in that the parameters in a following table are different, and the data such as the furnace pressure, etc., in the contrast example 4 is as shown in contrast table 4 below:

Contrast table 4

| Percentage of the equal-diameter length | Furnace pressure (Torr) | Flow rate of argon gas (SLPM) | Frequency of the dry pump (Hz) |
|---|---|---|---|
| 0% | 70 | 70 | 20 |
| 4% | 70 | 70 | 20 |
| 7% | 70 | 70 | 30 |
| 10% | 70 | 70 | 40 |
| 18% | 68 | 70 | 50 |
| 44% | 58 | 70 | 52 |

(continued)

| Percentage of the equal-diameter length | Furnace pressure (Torr) | Flow rate of argon gas (SLPM) | Frequency of the dry pump (Hz) |
|---|---|---|---|
| 74 % | 40 | 70 | 54 |
| 96% | 20 | 70 | 55 |
| 100% | 10 | 70 | 58 |

Implementation 13

The crystal-growth process (CZ method) of the monocrystalline silicon doped with 0.014% (the mass percentage) of gallium is as follows:

S1, in the material-melting stage, the temperature-adjustment stage, the seeding stage and the shoulder-expanding stage of the growth of the crystal, keeping the furnace pressure of the monocrystal furnace being 11-15 Torr, and the flow rate of argon gas being 100 SLPM.

S2, in the equal-diameter stage, at a moment when the percentage of the equal-diameter length of the crystal rod is L, the furnace pressure U corresponding to the moment is obtained through a detecting structure in the monocrystal furnace.

S3, in the equal-diameter stage, the furnace pressure U of the monocrystal furnace, the percentage L of the equal-diameter length of the crystal rod, the flow rate P of argon gas, and the frequency F of the dry pump meet $U = A*L + B*P + D*F + C$,

wherein $5 \leq A \leq 10$, $0.01 \leq B \leq 0.02$, $-0.6 \leq D \leq -0.2$, and $15 \leq C \leq 20$.

Among them, the value of the furnace pressure is within the range of $2\ Torr \leq U \leq 10\ Torr$, the value of the flow rate of argon gas is within the range of $50\ SLPM \leq P \leq 70\ SLPM$, and the value of the frequency of the dry pump is within the range of $20\ Hz \leq F \leq 60Hz$. The relevant parameters in this implementation are as shown in table 11 below:

Table 11

| Percentage of the equal-diameter length | Furnace pressure (Torr) |
|---|---|
| 0% | 10 |
| 4% | 7 |
| 7% | 5 |
| 10% | 4 |
| 18% | 3 |
| 44% | 2 |
| 74% | 2 |
| 96% | 2 |
| 100% | 2 |

Implementation 14

The crystal-growth process (CZ method) of the monocrystalline silicon doped with 0.014% (the mass percentage) of gallium is as follows:

S1, in the material-melting stage, the temperature-adjustment stage, the seeding stage and the shoulder-expanding stage of the growth of the crystal, keeping the furnace pressure of the monocrystal furnace being 11-15 Torr, and the flow rate of argon gas being 100 SLPM.

S2, in the equal-diameter stage, the percentage L of the equal-diameter length of the crystal rod, the furnace pressure U of the monocrystal furnace, the flow rate P of argon gas, and the frequency F of the dry pump are controlled to correspond to each other according to following table 6', and to be kept always meeting $U = A*L + B*P + D*F + C$,

wherein 5 ≤ A ≤ 10, 0.01 ≤ B ≤ 0.02, -0.6 ≤ D ≤ -0.2, and 15 ≤ C ≤ 20.

Among them, the value of the furnace pressure is within the range of 2 Torr ≤ U ≤ 10 Torr, the value of the flow rate of argon gas is within the range of 50 SLPM ≤ P ≤ 70 SLPM, and the value of the frequency of the dry pump is within the range of 20 Hz ≤ F ≤ 60Hz. The relevant parameters in this implementation are as shown in table 12 below:

Table 12

| Percentage of the equal-diameter length | Furnace pressure (Torr) | Flow rate of argon gas (SLPM) | Frequency of the dry pump (Hz) |
|---|---|---|---|
| 0% | 10 | 70 | 20 |
| 4% | 7 | 70 | 20 |
| 7% | 5 | 70 | 30 |
| 10% | 4 | 60 | 30 |
| 18% | 3 | 60 | 35 |
| 44% | 2 | 60 | 35 |
| 74 % | 2 | 50 | 40 |
| 96% | 2 | 50 | 50 |
| 100% | 2 | 50 | 60 |

Comparison example 5

The resistivity of the head and the effective resistivity of the tail of the crystal rod of the monocrystalline silicon with the percentage of 100% obtained in the contrast example 2, and that in the implementations 11-14 are compared as shown in comparison table 5 below:

Comparison table 5

| | Implementation 3' | Implementation 4' | Implementation 5' | Implementation 6' | Contrast example 2' |
|---|---|---|---|---|---|
| Resistivity of the head of the crystal rod | 1.01 | 1.01 | 1.01 | 1.01 | 1.01 |
| Effective resistivity of the tail of the crystal rod | 0.49 | 0.50 | 0.49 | 0.49 | 0.46 |

Referring to the above comparison table 5, under the condition that the resistivities of the heads of the crystal rods of the monocrystalline silicon with the percentage of 100% obtained are the same, the effective resistivities of the tails of the crystal rods in the implementations 11-14 are higher than that in the contrast example 2.

The above descriptions are only preferred embodiments of the present disclosure, and are not intended to limit the present disclosure in other forms. Any person skilled in the art may use the technical contents disclosed above to make changes or modifications on them to obtain equivalent embodiments of equivalent change. However, any simple amendment, equivalent change and modification made to the above embodiments according to the technical essence of the present disclosure without departing from the technical solution of the present disclosure still fall within a protection scope of the technical solutions of the present disclosure.

## Claims

1.    A crystal-pulling method for pulling monocrystalline silicon, **characterized in that** the crystal-pulling method comprises that a furnace pressure of a monocrystal furnace in an equal-diameter stage of growth of a crystal does not exceed 18 Torr, a flow rate of argon gas introduced into the monocrystal furnace is kept in a constant range, and the monocrystalline silicon is doped with a dopant.

2. The crystal-pulling method for pulling the monocrystalline silicon according to claim 1, **characterized in that** the furnace pressure of the monocrystal furnace is gradually reduced as a length of a crystal rod increases in the equal-diameter stage of the growth of the crystal.

3. The crystal-pulling method for pulling the monocrystalline silicon according to claim 2, **characterized in that** the furnace pressure of the monocrystal furnace in the equal-diameter stage of the growth of the crystal does not exceed 15 Torr; and preferably the furnace pressure of the monocrystal furnace does not exceed 10 Torr.

4. The crystal-pulling method for pulling the monocrystalline silicon according to claim 2, **characterized in that**, when an equal-diameter length of the monocrystalline silicon is any a length within a range of greater than 0 mm and less than 250 mm, the furnace pressure of the monocrystal furnace is controlled to be $U_{5a}$, and a value of $U_{5a}$ is within a range of 8-15 Torr; when the equal-diameter length of the monocrystalline silicon is within a range of greater than or equal to 250 mm and less than 600 mm, the furnace pressure of the monocrystal furnace is controlled to be $U_{5b}$, and a value of $U_{5b}$ is within a range of 4-12 Torr; and when the equal-diameter length of the monocrystalline silicon is equal to 600 mm or greater than 600 mm, the furnace pressure of the monocrystal furnace is controlled to $U_{be5c}$ and a value of $U_{5c}$ is within a range of 2-8 Torr, wherein $U_{5c} < U_{5b} < U_{5a}$.

5. The crystal-pulling method for pulling the monocrystalline silicon according to claim 2, **characterized in that** a process that the furnace pressure of the monocrystal furnace is gradually reduced, comprises:

   when the crystal grows to a preset length, obtaining a value of the furnace pressure, U, of the monocrystal furnace; and
   comparing the obtained value of the furnace pressure, U, of the monocrystal furnace with a preset value of the furnace pressure, $U_5$, and when $U > U_5$, reducing the furnace pressure, till $U \leq U_5$.

6. The crystal-pulling method for pulling the monocrystalline silicon according to claim 5, **characterized in that** the process that the furnace pressure of the monocrystal furnace is gradually reduced, comprises:

   when the crystal grows to the preset length, obtaining the value of the furnace pressure, U, of the monocrystal furnace;
   comparing the obtained value of the furnace pressure, U, of the monocrystal furnace with the preset value of the furnace pressure, $U_5$; and
   when $U \leq U_5$, keeping a frequency of a vacuum pump unchanged; and
   when $U > U_5$, increasing the frequency of the vacuum pump, then detecting the value of the furnace pressure, U, of the monocrystal furnace, and comparing a size of U with a size of $U_5$, and when $U \leq U_5$, keeping the frequency of the vacuum pump unchanged.

7. The crystal-pulling method for pulling the monocrystalline silicon according to claim 5, **characterized in that** the process that the furnace pressure of the monocrystal furnace is gradually reduced, comprises:

   when the equal-diameter length of the monocrystalline silicon grows to any a length within a range of greater than or equal to 100 mm and less than 350 mm, obtaining the value of the furnace pressure, U, of the monocrystal furnace; comparing the obtained value of the furnace pressure, U, of the monocrystal furnace with a preset value of the furnace pressure, $U_{51}$, and when $U > U_{51}$, reducing the furnace pressure, till $U \leq U_{51}$, wherein the value of $U_{51}$ is within a range of 6-14 Torr, and preferably the value of $U_{51}$ is within a range of 8-12 Torr;
   when the equal-diameter length of the monocrystalline silicon grows to any a length within a range of greater than or equal to 350 mm and less than 600 mm, obtaining the value of the furnace pressure, U, of the monocrystal furnace; comparing the obtained value of the furnace pressure, U, of the monocrystal furnace with a preset value of the furnace pressure, $U_{52}$, and when $U > U_{52}$, reducing the furnace pressure, till $U \leq U_{52}$, wherein the value of $U_{52}$ is within a range of 4-10 Torr, and preferably the value of $U_{52}$ is within a range of 5-8 Torr; and
   when the equal-diameter length of the monocrystalline silicon grows to any a length within a range of greater than or equal to 600 mm, obtaining the value of the furnace pressure, U, of the monocrystal furnace; comparing the obtained value of the furnace pressure, U, of the monocrystal furnace with a preset value of the furnace pressure, $U_{53}$; and when $U > U_{53}$, reducing the furnace pressure, till $U \leq U_{53}$, wherein the value of $U_{53}$ is within a range of 2-8 Torr, and preferably the value of $U_{53}$ is within a range of 2-6 Torr,

wherein $U_{53} < U_{52} < U_{51}$.

8. The crystal-pulling method for pulling the monocrystalline silicon according to claim 5, **characterized in that** the process that the furnace pressure of the monocrystal furnace is gradually reduced, comprises:

when the equal-diameter length of the monocrystalline silicon is any a length within a range of less than 10% of a total length of the crystal rod, obtaining the value of the furnace pressure, U, of the monocrystal furnace; comparing the obtained value of the furnace pressure, U, of the monocrystal furnace with a preset value of the furnace pressure, $U_{51}$; and when $U > U_{51}$, reducing the furnace pressure, till $U \le U_{51}$, wherein the value of $U_{51}$ is within a range of 4-10 Torr;
when the equal-diameter length of the monocrystalline silicon is any a length within a range of greater than or equal to 10% of the total length of the crystal rod and less than 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{52}$; and when $U > U_{52}$, reducing the furnace pressure, till $U \le U_{52}$, wherein the value of $U_{52}$ is within a range of 2-4 Torr; and
when the equal-diameter length of the monocrystalline silicon is any a length within a range of greater than or equal to 45% of the total length of the crystal rod, obtaining the value of the furnace pressure, U, of the monocrystal furnace; comparing the obtained value of the furnace pressure, U, of the monocrystal furnace with the preset value of the furnace pressure, $U_{53}$; and when $U > U_{53}$, reducing the furnace pressure, till $U \le U_{53}$, wherein the value of $U_{53}$ is within a range of 0-2 Torr,
wherein $U_{53} < U_{52} < U_{51}$.

9. The crystal-pulling method for pulling the monocrystalline silicon according to claim 5, **characterized in that**,

when the equal-diameter length of the monocrystalline silicon is any a length within a range of less than 10% of a total length of the crystal rod, the furnace pressure of the monocrystal furnace is controlled to be $U_{S501}$, and a value of $U_{S501}$ is within a range of 1-3 Torr;
when the equal-diameter length of the monocrystalline silicon is any a length within a range of greater than or equal to 10% of the total length of the crystal rod and less than 45% of the total length of the crystal rod, the furnace pressure of the monocrystal furnace is controlled to be $U_{S502}$, and a value of $U_{S502}$ is within a range of 0.3-2 Torr; and
when the equal-diameter length of the monocrystalline silicon is any a length within a range of greater than or equal to 45% of the total length of the crystal rod, the furnace pressure of the monocrystal furnace is controlled to be $U_{S503}$, and a value of $U_{S503}$ is within a range of 0.01-0.3 Torr,
wherein $U_{S503} < U_{S502} < U_{S501}$.

10. The crystal-pulling method for pulling the monocrystalline silicon according to claim 9, **characterized in that**,

when the equal-diameter length of the monocrystalline silicon is any a length within the range of less than 10% of the total length of the crystal rod, obtaining the value of the furnace pressure, U, of the monocrystal furnace; comparing the obtained value of the furnace pressure, U, of the monocrystal furnace with a preset value of the furnace pressure, $U_{S51}$; and when $U > U_{S51}$, reducing the furnace pressure, till $U \le U_{S51}$, wherein the value of $U_{S51}$ is within a range of 1-3 Torr;
when the equal-diameter length of the monocrystalline silicon is any a length within the range of greater than or equal to 10% of the total length of the crystal rod and less than 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S52}$; and when $U > U_{S52}$, reducing the furnace pressure, till $U \le U_{S52}$, wherein the value of $U_{S52}$ is within a range of 0.3-2 Torr; and
when the equal-diameter length of the monocrystalline silicon is any a length within the range of greater than or equal to 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S53}$; and when $U > U_{S53}$, reducing the furnace pressure, till $U \le U_{S53}$, wherein the value of $U_{S53}$ is within a range of 0.01-0.3 Torr,
wherein $U_{S53} < U_{S52} < U_{S51}$.

11. The crystal-pulling method for pulling the monocrystalline silicon according to claim 5, **characterized in that**,

when the equal-diameter length of the monocrystalline silicon is any a length within a range of less than 10% of a total length of the crystal rod, controlling the furnace pressure of the monocrystal furnace to be $U_{S501}$, wherein $U_{S501}$ does not exceed 500 mTorr;

when the equal-diameter length of the monocrystalline silicon is any a length within a range of greater than or equal to 10% of the total length of the crystal rod and less than 45% of the total length of the crystal rod, controlling the furnace pressure of the monocrystal furnace to be $U_{S502}$, wherein $U_{S502}$ does not exceed 300 mTorr; and

when the equal-diameter length of the monocrystalline silicon is any a length within a range of greater than or equal to 45% of the total length of the crystal rod, controlling the furnace pressure of the monocrystal furnace to be $U_{S503}$, wherein $U_{S503}$ does not exceed 100 mTorr,

wherein $U_{S503} < U_{S502} < U_{S501}$.

12. The crystal-pulling method for pulling the monocrystalline silicon according to claim 11, **characterized in that**,

when the equal-diameter length of the monocrystalline silicon is any a length within the range of less than 10% of the total length of the crystal rod, obtaining the value of the furnace pressure, U, of the monocrystal furnace; comparing the obtained value of the furnace pressure, U, of the monocrystal furnace with a preset value of the furnace pressure, U ssi; and when $U > U_{S51}$, reducing the furnace pressure, till $U \leq U_{S51}$, wherein $U_{S51}$ does not exceed 500 mTorr;

when the equal-diameter length of the monocrystalline silicon is any a length within the range of greater than or equal to 10% of the total length of the crystal rod and less than 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S52}$; and when $U > U_{S52}$, reducing the furnace pressure, till $U \leq U_{S52}$, wherein the value of $U_{S52}$ does not exceed 300 mTorr; and

when the equal-diameter length of the monocrystalline silicon is any a length within the range of greater than or equal to 45% of the total length of the crystal rod, obtaining the value of the furnace pressure, U, of the monocrystal furnace; comparing the obtained value of the furnace pressure, U, of the monocrystal furnace with a preset value of the furnace pressure, $U_{S53}$, and when $U > U_{S53}$, reducing the furnace pressure, till $U \leq U_{S53}$, wherein the value of $U_{S53}$ does not exceed 100 mTorr,

wherein $U_{S53} < U_{S52} < U_{S51}$.

13. The crystal-pulling method for pulling the monocrystalline silicon according to any one of claims 1-3, **characterized in that** the crystal-pulling method further comprises: controlling the furnace pressure in a material-melting/feeding stage, a seeding stage, a shoulder-expanding stage and a shoulder-turning stage previous to the equal-diameter stage; and

preferably the furnace pressure in the material-melting/feeding stage, the seeding stage, the shoulder-expanding stage and the shoulder-turning stage previous does not exceed 18 Torr, and further preferably the furnace pressure does not exceed 2 Torr.

14. The crystal-pulling method for pulling the monocrystalline silicon according to claim 1, **characterized in that**, at least in a time in the equal-diameter stage of the growth of the crystal, a value of the furnace pressure, U, of the monocrystal furnace, a percentage L of an equal-diameter length of a crystal rod, the flow rate P of argon gas, and a frequency F of a vacuum pump meet:

$$U = A*L + B*P + D*F + C,$$

wherein $1 \leq A \leq 10$, $0.01 \leq B \leq 0.02$, $-0.6 \leq D \leq -0.2$, and $10 \leq C \leq 25$, and

a unit of the value of the furnace pressure, U, of the monocrystal furnace is Torr, the percentage L of the equal-diameter length of the crystal rod is a percentage of a pulled length of the crystal rod to a total length of the crystal rod, a unit of the flow rate P of argon gas is SLPM, and a unit of the frequency F of the vacuum pump is Hz.

15. The crystal-pulling method for pulling the monocrystalline silicon according to claim 14, **characterized in that** the furnace pressure meets 0.001 Torr $\leq U \leq$ 15 Torr, the flow rate of argon gas meets 0 SLPM $< P \leq$ 70 SLPM, and the frequency of the vacuum pump meets 20 Hz $\leq F \leq$ 60 Hz.

16. The crystal-pulling method for pulling the monocrystalline silicon according to claim 1, **characterized in that** a range of the furnace pressure of the monocrystal furnace in the equal-diameter stage of the growth of the crystal is 0-15 Torr, and preferably 2-10 Torr.

**17.** The crystal-pulling method for pulling the monocrystalline silicon according to claim 14, **characterized in that** the flow rate of argon gas introduced into the monocrystal furnace is 40-100 SLPM, and preferably 50-70 SLPM.

**18.** The crystal-pulling method for pulling the monocrystalline silicon according to claim 1, **characterized in that**, at least in a time in the equal-diameter stage of the growth of the crystal, a value of the furnace pressure, U, of the monocrystal furnace, a percentage L of an equal-diameter length of a crystal rod, the flow rate P of argon gas, and a frequency F of a vacuum pump meet:

$$U = A*L + B*P + D*F + C,$$

wherein $5 \leq A \leq 10$, $0.01 \leq B \leq 0.02$, $-0.6 \leq D \leq -0.2$, and $15 \leq C \leq 20$, and
a unit of the value of the furnace pressure, U, of the monocrystal furnace is Torr, the percentage L of the equal-diameter length of the crystal rod is a percentage of a pulled length of the crystal rod to a total length of the crystal rod, a unit of the flow rate P of argon gas is SLPM, and a unit of the frequency F of the vacuum pump is Hz.

**19.** The crystal-pulling method for pulling the monocrystalline silicon according to claim 18, **characterized in that** the value of the furnace pressure is within a range of $2\ \text{Torr} \leq U \leq 10\ \text{Torr}$, the flow rate of argon gas is within a range of $50\ \text{SLPM} \leq P \leq 70\ \text{SLPM}$, and the frequency of the dry pump is within a range of $20\ \text{Hz} \leq F \leq 60\ \text{Hz}$.

**20.** The crystal-pulling method for pulling the monocrystalline silicon according to any one of claims 1-19, **characterized in that** the dopant is gallium.

Axial variation trends of resistivity during crystal pulling under different furnace pressures

FIG. 1

Variation trends of resistivities in an axial direction when the crystal pulling is performed under different furnace pressures

FIG. 2

<div align="center">

**INTERNATIONAL SEARCH REPORT**

</div>

| | |
|---|---|
| | International application No. |
| | **PCT/CN2022/070545** |

**A. CLASSIFICATION OF SUBJECT MATTER**

C30B 29/06(2006.01)i; C30B 15/20(2006.01)i

According to International Patent Classification (IPC) or to both national classification and IPC

**B. FIELDS SEARCHED**

Minimum documentation searched (classification system followed by classification symbols)

C30B29/-; C30B15/-

Documentation searched other than minimum documentation to the extent that such documents are included in the fields searched

Electronic data base consulted during the international search (name of data base and, where practicable, search terms used)

CNPAT, CNKI, EPODOC, WPI, 等径, 炉压, 压力, 电阻率, 掺杂, straight, pressure, dope+, resistivity

**C. DOCUMENTS CONSIDERED TO BE RELEVANT**

| Category* | Citation of document, with indication, where appropriate, of the relevant passages | Relevant to claim No. |
|---|---|---|
| PX | CN 112981520 A (LONGI GREEN ENERGY TECHNOLOGY CO., LTD.) 18 June 2021 (2021-06-18) claims 1-12, embodiments 1-6 | 1-8, 16-20 |
| PX | CN 113652737 A (LONGI GREEN ENERGY TECHNOLOGY CO., LTD.) 16 November 2021 (2021-11-16) claims 9-15 | 9-15 |
| X | CN 104357901 A (INNER MONGOLIA ZHONGHUAN SOLAR MATERIAL CO., LTD.) 18 February 2015 (2015-02-18) embodiment 1 | 1, 13, 16, 17, 20 |
| Y | CN 104357901 A (INNER MONGOLIA ZHONGHUAN SOLAR MATERIAL CO., LTD.) 18 February 2015 (2015-02-18) embodiment 1 | 2-12, 14, 15, 18, 19 |
| Y | CN 102162124 A (TIANJIN HUAN-OU SEMICONDUCTOR MATERIAL TECHNOLOGY CO., LTD.) 24 August 2011 (2011-08-24) description, paragraphs 5-6 | 2-12, 14, 15, 18, 19 |
| A | JP 2012206874 A (COVALENT MAT CORP.) 25 October 2012 (2012-10-25) entire description | 1-20 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 February 2022** | **01 March 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## EP 4 257 734 A1

| INTERNATIONAL SEARCH REPORT Information on patent family members | | | | International application No. PCT/CN2022/070545 | | |
|---|---|---|---|---|---|---|
| Patent document cited in search report | | | Publication date (day/month/year) | Patent family member(s) | | Publication date (day/month/year) |
| CN | 112981520 | A | 18 June 2021 | None | | |
| CN | 113652737 | A | 16 November 2021 | None | | |
| CN | 104357901 | A | 18 February 2015 | None | | |
| CN | 102162124 | A | 24 August 2011 | CN 102162124 | B | 22 August 2012 |
| JP | 2012206874 | A | 25 October 2012 | JP 5595318 | B2 | 24 September 2014 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110984273
- CN 202110024166